# EUROPÄISCHE PATENTSCHRIFT

(11) **EP 1 899 495 B1**
(45) Veröffentlichungstag und Bekanntmachung des Hinweises auf die Patenterteilung: **18.01.2012**
(21) Anmeldenummer: 06761727.4
(22) Anmeldetag: 30.06.2006
(51) Int. Cl.: C23C 14/24, C23C 14/20

(54) **ERSTBENETZUNGSHILFSMATERIAL FÜR EINEN VERDAMPFERKÖRPER**
INITIAL WETTING AUXILIARY MATERIAL FOR A VAPORISER BODY
MATIERE AUXILIAIRE DE MOUILLAGE INITIAL POUR UN CORPS DE VAPORISATION

(30) Priorität: 01.07.2005 DE 102005030862
(43) Veröffentlichungstag der Anmeldung: 19.03.2008
(73) Patentinhaber: Kennametal Sintec Keramik GmbH, 86956 Schongau (DE)
(72) Erfinder: GOETZ, Ulrich, 87642 Halblech (DE); NÜRNBERGER, Michael, 86956 Altenstadt (DE)
(74) Vertreter: Freier, Rüdiger
(86) Internationale Anmeldenummer: PCT/DE2006/001123
(87) Internationale Veröffentlichungsnummer: WO 2007/003167

(56) Entgegenhaltungen:
- WO-A2-2006/029615
- DE-A1- 2 535 569
- DE-A1- 3 239 131
- DE-A1- 19 821 772
- GB-A- 1 263 088
- US-A- 3 216 710

## Beschreibung

Die Erfindung betrifft ein Erstbenetzungshilfsmaterial zum Aufbringen auf die Verdampferfläche eines elektrisch beheizbaren keramischen Verdampferkörpers, welcher zum Betreiben in einer PVD-Metallisierungsanlage zum Verdampfen von Aluminium vorgesehen ist. Ferner betrifft die Erfindung einen elektrisch beheizbaren keramischen Verdampferkörper mit einem auf der Verdampferfläche aufgebrachten erfindungsgemäßen Erstbenetzungshilfsmaterial. Die Erfindung betrifft ferner ein Verfahren zum Herrichten eines elektrisch beheizbaren keramischen Verdampferkörpers, wobei auf die Verdampferfläche des Verdampferkörpers vor dessen Erwärmung ein erfindungsgemäßes Erstbenetzungshilfsmaterial aufgebracht wird.

Das gebräuchliche Verfahren zum Beschichten von flexiblen Substraten mit Metallen, insbesondere mit Aluminium, ist das sog. Vakuum-Bandmetallisieren gemäß der PVD (physical vapor deposition)-Technik. Als flexible Substrate kommen z.B. Papier, Kunststofffolien und Textilien in Frage und als Metall wird überwiegend Aluminium eingesetzt. So beschichtete Substrate finden breite Anwendung für Verpackungs-, Dekorationszwecke, bei der Kondensatorherstellung und in der Umwelttechnik (Isolation).

Die Beschichtung der flexiblen Substrate erfolgt in sog. Metallisierungsanlagen. In der Metallisierungsanlage wird das zu beschichtende Substrat über eine gekühlte Walze geführt und dabei einem Metalldampf ausgesetzt, der sich auf der Substratoberfläche als dünne Metallschicht niederschlägt. Zur Erzeugung des erforderlichen konstanten Dampfstromes werden elektrisch beheizbare Verdampferkörper eingesetzt, insbesondere in Form sogenannter Verdampferschiffchen, die auf etwa 1450-1600°C erhitzt werden. Metalldraht wird kontinuierlich zugeführt, auf der Oberfläche der Verdampferschiffchen verflüssigt und im Vakuum bei ca. 10⁻⁴ mbar verdampft. Als Metall wird hauptsächlich Aluminium eingesetzt.

Nicht flexible Substrate werden gemäß der PVD-Technik batchweise in einem diskontinuierlichen Prozess, insbesondere mittels Flash-Verdampfung, beschichtet. Nicht flexible Substrate sind z.B. Fernsehbildschirme und Kunststoffteile.

Die für das kontinuierliche Verfahren und das diskontinuierliche Verfahren eingesetzten Verdampferkörper bestehen in der Regel aus heißgepresstem keramischem Material, das als Hauptkomponente Titandiborid und Bornitrid enthält. Titandiborid ist dabei die elektrisch leitfähige Komponente, Bornitrid die elektrisch isolierende Komponente, die miteinander gemischt zu bestimmten spezifischen Widerständen führen.

In der Praxis ist die Benetzung des zu verdampfenden Metalls auf dem Verdampferkörper zu Beginn des Metallisierungsprozesses unvollständig. Dies führt dazu, dass aufgrund der geringeren Benetzungsfläche zu Beginn des Metallisierungsprozesses nur verminderte Abdampfraten (Kilogramm Metall/Zeiteinheit) realisiert werden können.

>

DE 25 35 569 A1 offenbart einen Behälter für die Verdampfung von Metall aus einem elektrisch leitfähigen Keramikmaterial, wobei die mit dem geschmolzenen Metall in Berührung kommende Oberfläche des Behälters mit einer Beschichtung versehen ist.

DE 198 21 772 A1 offenbart ein keramisches Verdampferschiffchen aus einer leitenden und einer nicht leitenden Komponente, wobei die leitende Komponente an der Verdampfungsfläche angereichert ist.

Die Anmelderin hat sich hinsichtlich der DE 10 2005 020 945 B4 durch Vorlage gesonderter Patentansprüche für Deutschland freiwillig eingeschränkt.

Durch die Erfindung werden ein Erstbenetzungshilfsmaterial, ein Verdampferkörper mit dem erfindungsgemäßen Erstbenetzungshilfsmaterial und ein Verfahren der eingangs genannten Art geschaffen, womit eine verbesserte Erstbenetzung des Verdampferkörpers durch zu verdampfendes Aluminium erreicht wird, um damit von Beginn des Verdampferbetriebs an erhöhte Abdampfraten zu erzielen.

Die Erfindung stellt ein Erstbenetzungshilfsmaterial zum Aufbringen auf die Verdampferfläche eines elektrisch beheizbaren keramischen Verdampferkörpers, welcher zum Betreiben in einer PVD-Metallisierungsanlage zum Verdampfen von Aluminium vorgesehen ist und Stickstoff, insbesondere in Form von Bornitrid, als eine Materialkomponente enthält, bereit. Das Erstbenetzungshilfsmaterial gemäß der Erfindung ist ein Schichtmaterial, wobei unter Schichtmaterial wenigstens eine Schicht, die auch als Platten- oder Folienmaterial gestaltet sein kann, und/oder ein Pulvermaterial, und weist mindestens zwei Komponenten auf: Aluminium als erste Komponente in einer Beschaffenheit, dass es nach dem Start des Betriebs des Verdampferkörpers auf dessen Verdampferfläche schmilzt und mit dem Stickstoff des Verdampferkörpers unter Ausbildung einer Aluminiumnitridschicht auf der Verdampferfläche reagiert, und ein Benetzungsmittel (Benetzungsagens) als zweite Komponente, mittels dessen eine gleichmäßige und großflächige Verteilung von geschmolzenem Aluminium auf der Verdampferfläche begünstigt wird.

Der Verdampferkörper wird direkt, d.h. im direkten Stromdurchgang, widerstandsbeheizt.

Das nach dem Start des Verdampfers verflüssigte Aluminium des Erstbenetzungshilfsmaterials wird mittels des Benetzungsmittels schnell und flächendeckend auf der Verdampferfläche des Verdampferkörpers verteilt, so dass die Verdampferfläche bereits zu Beginn des Aufheizvorgangs nahezu vollständig mit Aluminium benetzt ist. Das Benetzungsmittel bewirkt hierbei insbesondere eine Verringerung des Benetzungswinkels des schmelzenden Aluminiums. Das dadurch gut verteilte Aluminium reagiert dann mit dem Bornitrid des Verdampferkörpers zu Aluminiumnitrid. Das so auf der Verdampferoberfläche gebildete Aluminiumnitrid wird von Aluminium wesentlich besser benetzt als das Bornitrid des Verdampferkörpers. Bei fachgerechter Betreibung des Verdampferkörpers bleibt die durch das Erstbenetzungshilfsmaterial ausgebildete aktive Benetzungsfläche (=auf der Verdampferfläche des Verdampferkörpers generierte Aluminiumnitridschicht) über die gesamte Lebensdauer des Verdampferkörpers hinweg erhalten.

Mit der mit dem Erstbenetzungshilfsmaterial beim Start (= Aufheizvorgang) des Verdampferkörpers auf dessen Verdampferoberfläche sehr schnell bereitstellbaren Aluminiumnitridschicht, auf welche dann das zu verdampfende Aluminiummaterial kontinuierlich aufgebracht wird, wird eine erhebliche Verbesserung der Benetzung/Beschichtung der Verdampferoberfläche erzielt, da die Schicht aus Aluminiumnitrid im Vergleich zu z.B. Bornitrid eine starke Reduzierung des Benetzungswinkels des Aluminiums (Reduzierung der Oberflächenspannung) gegenüber der Verdampferfläche des Verdampferkörpers bewirkt, so dass die Aluminiumnitridschicht und damit die Verdampferoberfläche schneller benetzt werden. Das Aluminium des Erstbenetzungshilfsmaterials schmilzt beim Betriebsstart des Verdampferkörpers, d.h. wenn durch diesen z.B. elektrischer Strom geleitet wird, um diesen aufgrund seines ohmschen Widerstandes elektrisch auf eine Betriebstemperatur von insbesondere 1450-1600°C aufzuheizen, wobei das Benetzungsmittel des Erstbenetzungshilfsmaterials eine schnelle und gleichmäßige Verteilung des Aluminiums des Erstbenetzungshilfsmaterials auf der Verdampferoberfläche bewirkt, wobei die zugehörige mit dem geschmolzenen Aluminium des Erstbenetzungshilfsmaterials benetzte Fläche auf dem Verdampferkörper die Erstbenetzungsfläche darstellt. Dadurch wird über die gesamte mit dem Erstbenetzungshilfsmaterial versehene Verdampferoberfläche (= spätere Erstbenetzungsfläche) bereits in der Aufheizphase des Verdampferkörpers eine In-Situ-Reaktion des Aluminiums mit dem Stickstoff im Verdampferkörper erreicht, wodurch schnell und sicher die wie oben erwähnt vorteilhafte Aluminiumnitridschicht ausgebildet wird.

Am Ende des Aufheizvorgangs des Verdampferkörpers liegt dann also bereits nahezu über die gesamte Verdampferfläche hinweg eine Aluminiumnitridschicht vor, wobei gleichzeitig auch der Dampfdruck des Aluminiums den Druck aus der Gasphase erreicht bzw. diesen überschreitet, so dass das überschüssige Aluminium des Erstbenetzungshilfsmaterials verdampft. Das anschließende kontinuierliche Verdampfen des zu verdampfenden Aluminiums erfolgt daher von einer deutlich größeren aktiven Aluminiumbadfläche (=durch das kontinuierlich zugeführte, geschmolzene Aluminium eingenommene Fläche auf der Verdampferfläche des Verdampferkörpers) aus und mit einer wesentlich erhöhten Abdampfrate schon zu Beginn des Abdampfprozesses. Mit der erreichten großflächigen Erstbenetzung durch das Aluminium des Erstbenetzungshilfsmaterials gleich zu Beginn des Aufheizvorgangs wird ferner auch die anfängliche thermische Belastung des Verdampferkörpers reduziert und dadurch seine Standzeit erhöht und seine elektrische Steuerung erleichtert.

Durch die gleichmäßige und vollflächige Erstbenetzung wird zudem die sog. Spritzerbildung erheblich reduziert. Spritzer entstehen unter anderem durch schlagartiges Verdampfen von Aluminium und stellen Fehlstellen auf dem beschichteten Substrat dar. Bei einer unvollständigen Benetzung/Beschichtung der Verdampferfläche und pulsierenden Aluminiumbadbewegungen wird ständig Aluminium von kühleren, benetzten Teilen der Verdampferfläche auf heißere, unbenetzte Teile der Verdampferfläche gebracht, was zu vielen kleinen Spritzern führt. Durch die durch das erfindungsgemäße Erstbenetzungshilfsmaterial ausgebildete gleichmäßige und vollflächige Benetzungsschicht auf der Verdampferfläche wird verhindert, dass das Aluminium auf Grund von Temperaturgradienten schlagartig auf der Verdampferfläche verdampft, so dass die Spritzerbildung erheblich reduziert wird.

Neben der Verwendung des Erstbenetzungshilfsmaterials für den kontinuierlichen Betrieb des Verdampferkörpers bzw. die kontinuierliche Zufuhr von Aluminium auf die Verdampferfläche, kann das erfindungsgemäße Erstbenetzungshilfsmaterial ebenso zum Herrichten von Verdampferkörpern verwendet werden, die zum diskontinuierlichen Verdampfen von Aluminium und Beschichten von nicht flexiblen Substraten mittels eines Flash-Verdampfers eingesetzt werden.

Der Verdampferkörper ist vorteilhaft aus Bornitrid als Isolierkomponente und Stickstofflieferant zur Ausbildung der Aluminiumnitridschicht und aus Titandiborid als elektrisch leitende Komponente. Das Bornitrid und das Titandiborid sind bevorzugt zu jeweils 50 Gew.% im Verdampferkörpermaterial enthalten.

Das Erstbenetzungshilfsmaterial ist ferner sehr einfach herstellbar und an dem Verdampferkörper anbringbar. So weist das Erstbenetzungshilfsmaterial insbesondere einfach ein Klebemittel, wie insbesondere Acrylat-Kleber, auf, mittels dessen das Erstbenetzungshilfsmaterial auf der Verdampferfläche klebehaftend anbringbar ist. Das Erstbenetzungshilfsmaterial kann jedoch auch einfach auf den Verdampferkörper auflegbar gestaltet sein, wenn es z.B. folienförmig/plattenförmig ausgebildet ist, oder auf den Verdampferkörper aufstreubar sein, wenn es z.B. pulverförmig ausgebildet ist. Das Erstbenetzungshilfsmaterial kann auch eine Kombination eines Folien/Platenmaterials mit einem Pulvermaterial sein. Bevorzugt ist der Verdampferkörper mit einer Kavität versehen, in welcher die Folie und/oder das Pulver in loser Form sicherer eingebracht sind. Es kann auch ein pulverförmiges Benetzungsmittel einfach auf die Verdampferoberfläche des Verdampferkörpers gestreut oder gewalzt und dann von einer lose aufgelegten oder mittels eines Klebemittels aufgeklebten Aluminiumfolie oder von einem Aluminiumblech abgedeckt sein.

Ferner weist das Erstbenetzungshilfsmaterial vorzugsweise Zinn als zusätzliche Materialkomponente auf, wobei das Zinn in elementarer Form oder in gebundener Form vorliegen kann. Das Zinn, welches insbesondere in Pulverform mit einer maximalen Korngröße von 0,02 bis 0,06 mm, insbesondere 0,045 mm, bereitgestellt ist, übernimmt ab Temperaturen von über 230°C durch Ausbildung einer schmelzflüssigen Phase die Haftwirkung des Klebemittels, wodurch eine Haftung/Fixierung des Erstbenetzungshilfsmaterials auf der Verdampferoberfläche des Verdampferkörpers auch bei erhöhten Temperaturen, nachdem sich der Klebstoff zersetzt bzw. nachdem der Klebstoff verdampft ist, sichergestellt ist. Wichtig ist dabei, dass das Zinn die Haftwirkung übernimmt, noch bevor das Klebemittel verdampft ist, um ein Haften des Erstbenetzungsmaterials über den gesamten Temperaturbereich sicherzustellen. Auf Grund seiner Schmelztemperatur und seines Dampfdrucks ist Zinn hierfür besonders gut geeignet, da es im Vergleich zu seiner Schmelztemperatur einen relativ niedrigen Dampfdruck aufweist, welcher in etwa dem des Aluminiums entspricht, so dass durch das Zinn in Kombination mit dem Klebemittel über das gesamte Temperaturfenster des Prozesses die Haftung des Erstbenetzungshilfsmaterials auf der Verdampferfläche gewährleistet ist. Ferner, da der Dampfdruck von Zinn in etwa mit dem von Aluminium übereinstimmt, wird das Zinn gegen Ende des Aufheizvorgangs, bei Erreichen der maximalen Aufheiztemperatur vollständig, d.h. rückstandslos, verdampft. Das Zinn kann direkt dem Klebemittel und/oder dem Benetzungsmittel zugemischt und/oder dem Aluminium zulegiert sein. Es sei darauf hingewiesen, dass sich die Erfindung nicht auf den Einsatz von Zinn als Haftmittel für einen erhöhten Temperaturbereich beschränkt, sondern vielmehr auch andere Materialkomponenten verwendet werden können, welche ein ähnliches Temperaturfenster hinsichtlich ihres Schmelz- und Siedepunkts aufweisen. Dabei ist vor allem wichtig, dass die gewählte Materialkomponente die geforderte Haftwirkung noch vor der Zersetzung/Verdampfung des Klebemittels entfaltet und etwa gleiche Dampfdruckverhältnisse wie Aluminium aufweist, so dass keine Rückstände gebildet werden. Auch wenn die Kombination von Zinn und Klebemittel eine nahezu ideale Haftwirkung über den gesamten Temperaturbereich hinweg bietet, kann das Zinn oder das Klebemittel auch ohne die jeweils andere Materialkomponente in dem Erstbenetzungshilfsmaterial vorliegen.

Bevorzugt enthält das Benetzungsmittel des Erstbenetzungshilfsmaterials mindestens 30 Gew.%, vorzugsweise 40 Gew.%, Zirkonium, Molybdän, Titan oder eine Kombination davon als Materialkomponente. Die genannten Komponenten können dabei in elementarer Form, als Metalllegierung oder gebunden vorliegen. In gebundener Form liegen die Komponenten vorzugsweise als Boride und/oder Silizide und/oder Nitride und/oder Carbide und/oder als Carbonitride, insbesondere als Borid und/oder Silizid, vor, nicht jedoch oxidiert. Es ist wichtig, dass die Verbindungen unter den in der Metallisierungsanlage gegebenen Aufheizbedingungen im Kontakt mit flüssigem Aluminium freies Titanmetall/Molybdänmetall/Zirkoniummetall bilden.

Insbesondere ist das Benetzungsmittel Titandiborid, Titanmetall, Zirkoniumdiborid, Zirkoniummetall, Titandisilizid, Zirkoniumdisilizid, Molybdändisilizid, Molybdänmetall, Ferrosiliziumdititanat (FeSiTi₂) oder eine Kombination davon.

Das Benetzungsmittel kann z.B. pulverförmig ausgebildet, insbesondere mit einer Korngröße von kleiner oder gleich 0,2 mm, sein oder in Form eines Legierungsbestandteils mit dem Aluminium des Erstbenetzungshilfsmaterials als eine Aluminiumlegierung vorgesehen sein. Das Aluminium des Erstbenetzungshilfsmaterials kann z.B. in Form einer Aluminiumfolie bzw. eines Aluminiumblechs mit einer Dicke von 0,01 bis 4 mm, insbesondere einer Aluminiumfolie mit einer Dicke von 0,01-0,1 mm oder einem Aluminiumblech mit einer Dicke von 0,2-0,3 mm, vorzugsweise 0,024-0,26 mm, ausgebildet sein; hierbei ist nach einer bevorzugten Ausführungsform das Benetzungsmittel auf die Aluminiumfolie bzw. das Aluminiumblech aufgebracht, vorzugsweise aufgewalzt. Nach einer anderen Ausführungsform der Erfindung ist ein Pulvergemisch aus Zinn und Benetzungsmittel auf die Aluminiumfolie bzw. das Aluminiumblech aufgebracht, vorzugsweise durch Aufwalzen oder Aufspritzen des Pulvergemisches. Das Aluminium kann auch pulverförmig, insbesondere mit einer Korngröße von kleiner oder gleich 0,5 mm vorgesehen sein.

Nach einer anderen Ausführungsform der Erfindung ist das Aluminium des Erstbenetzungshilfsmaterials in Form einer Folie oder eines Blechs aus einer Aluminiumlegierung ausgebildet, welche außer dem Aluminium das Benetzungsmittel als Legierungsbestandteil enthält. Als weiterer Legierungsbestandteil kann dem Aluminium Zinn zulegiert sein. Nach einer alternativen Ausführungsform sind das Aluminium des Erstbenetzungshilfsmaterials und das Benetzungsmittel und vorzugsweise Zinn zu einem Pulvergemisch gemischt. Im Falle eines Aufklebens der Aluminiumschicht auf den Verdampferkörper, z.B. mittels eines Acrylat-Klebers, verhindert das Zinn, entsprechend den obigen Erläuterungen, dass die Aluminiumfolie bzw. das Aluminiumblech durch im Betrieb schmelzenden und verdampfenden bzw. sich zersetzenden Kleber vom Verdampfer abgehoben wird, weil das Zinn im Schmelzzustand eine ausreichende Haftwirkung mit sich bringt. Alternativ könnte man auch eine poröse Aluminium-Folie bzw. ein poröses Aluminiumblech vorsehen, durch die oder durch das der Kleber-Dampf entweichen kann, ohne dass die Folie bzw. das Blech abgehoben wird.

Nach einer noch anderen Ausführungsform ist das Erstbenetzungshilfsmaterial als eine Suspension aus flüssigem Klebemittel, insbesondere organischem Kleber oder Wachs, ausgebildet, in welchem das Pulvergemisch aus Aluminium, Benetzungsmittel und vorzugsweise Zinn dispergiert ist. Dies erlaubt es, das Erstbenetzungshilfsmaterial als Schicht mittels einfachen Aufstreichens auf dem Verdampferkörper auszubilden. Das flüssige Klebemittel stellt eine Matrix, insbesondere eine organische Matrix, dar, in welcher das Pulvergemisch eingebunden ist. Nach einer bevorzugten Ausführungsform weist die Suspension z.B. Parrafin-Stearat-Wachs, Titan- und/oder Titandiborid-Pulver mit einer maximalen Korngröße von 0,015 mm, Aluminiumpulver mit einer maximalen Korngröße von 0,5 mm und vorzugsweise Zinnpulver mit einer maximalen Korngröße von 0,02 bis 0,06 mm, insbesondere 0,045 mm, auf. Das Wachs wird z.B. auf eine Temperatur von ca. 150°C aufgeheizt, wobei dann das Aluminium, das Benetzungsmittel und gegebenenfalls das Zinn unter Erstellung der Suspension in das heiße Wachs eingerührt werden. Die Wachssuspension kann dann in diesem erwärmten Zustand auf den Verdampfer, insbesondere in eine Kavität des Verdampfers hinein, aufgebracht werden. Anschließend wird die Wachssuspension durch Abkühlen verfestigt, so dass der derart präparierte Verdampferkörper ausgeliefert/verschickt werden kann. Vorzugsweise weist die Suspension daher einen Schmelzpunkt von über 70°C auf. Zudem kann die verfestigte Wachssuspension mit einer Prägung zur Übermittlung von Informationen, z.B. von Betriebshinweisen oder Werbung, versehen werden. Beim Aufheizen des Verdampferkörpers schmilzt und verdampft bzw. zersetzt sich das Wachs, so dass zunächst das Aluminium und das Benetzungsmittel zum Ausbilden der Aluminiumnitridschicht sowie gegebenenfalls das Zinn zurückbleiben, wobei das Zinn letztlich zusammen mit dem verbleibenden Aluminium verdampft wird. Nach einer anderen bevorzugten Ausführungsform weist die Suspension z.B. Aluminiumpulver, Titanund/oder Titandiborid-Pulver, Zucker, Glykol und vorzugsweise Zinn auf. Bei Verwendung von sich nicht bei Zimmertemperatur verfestigenden Suspensionen oder losem Pulver als Erstbenetzungshilfsmaterial, kann der damit hergerichtete Verdampferkörper z.B. mit einer selbsthaftenden Folie oder einer sonstigen Abdeckung versehen sein, die beim Transport verhindert, dass die Suspension bzw. das Pulver aus z.B. einer Kavität im Verdampferkörper herausgelangt. Die Abdeckung kann z.B. hitzeempfindlich sein, so dass sie dann im Betrieb des Verdampferkörpers automatisch zerstört wird oder aber auch abnehmbar, wie z.B. in Form einer Abziehfolie, vorgesehen sein.

Das Erstbenetzungshilfsmaterial kann seinerseits eine Mehrschichtstruktur, aus z.B. einer Aluminiumschicht, einer auf der Aluminiumschicht ganzflächig aufgebrachten Benetzungsmittelschicht, vorzugsweise einer auf der Benetzungsmittelschicht aufgebrachten Schicht aus Zinnpulver und einer auf der Benetzungsmittelschicht bzw. der Zinnpulverschicht aufgebrachten Klebeschicht sein, mittels deren dann das Erstbenetzungshilfsmaterial wie ein Haftetikett auf den Verdampferkörper aufgebracht wird. Der Kleber der Klebeschicht ist insbesondere derart gewählt, dass er sich beim Erhitzen des Verdampferkörpers bei einer Temperatur von 250°C oder mehr zersetzt und komplett, d.h. annähernd rückstandslos, verdampft. Ein solcher Kleber ist z.B. Acrylat-Kleber. Das Zinnpulver übernimmt wie oben beschrieben durch Ausbildung einer Schmelze die Haftwirkung bei Temperaturen über 230°C, wobei der Übergang der Haftwirkung fließend bzw. überlappend erfolgt, d.h., dass in einem Temperaturbereich von ca. 230°C bis ca. 260°C die Haftung/Fixierung des Erstbenetzungshilfsmaterials auf der Verdampferfläche durch das Klebemittel und die Zinnschmelze erfolgt. Das Zinnpulver ist bevorzugt einfach mit dem Kleber vermischt, so dass dann die separate Zinnschicht entfällt.

Nach einer Ausführungsform der Erfindung ist das Erstbenetzungshilfsmaterial als Dualschicht ausgebildet, mit einer ersten Schicht aus einem Gemisch aus organischem Acrylat-Kleber und dem Benetzungsmittel und vorzugsweise Zinnpulver und mit einer zweiten Schicht aus Aluminium oder einer Aluminiumlegierung, wobei die Dicke der zweiten Schicht bevorzugt größer als die Dicke der ersten Schicht ist. Hierbei ist die erste Schicht vorzugsweise 0,02-0,06 mm, bevorzugt 0,050 mm, dick, wobei das Benetzungsmittel Titan- und/oder Titandiboridpulver mit einer Korngröße von 0,01-0,02 mm, insbesondere 0,015 mm, ist und mit einem Gewichtsanteil von 15-40 Gew.%, insbesondere 30 Gew.%, in der ersten Schicht enthalten ist, und wobei das Zinnpulver mit einem Gewichtsanteil von 5-30 Gew.%, insbesondere 30 Gew%, in der ersten Schicht enthalten ist. Die Dicke der zweiten Schicht beträgt 0,045-4 mm, vorzugsweise 0,045-0,1 mm, insbesondere 0,055 mm, oder 0,2-0,3 mm, insbesondere 0,24-0,26 mm.

Die Aluminiumlegierung enthält bevorzugt 90-97 Gew.% metallisches Aluminium, inklusive Verunreinigungen, und als Benetzungsmittel 3-10 Gew.% Titan.

Nach einer anderen Ausführungsform der Erfindung ist das Erstbenetzungshilfsmaterial als Dreifach- oder Dreilagenschicht ausgebildet, mit einer von der Aluminiumfolie oder dem Aluminiumblech gebildeten ersten Schicht, einer auf die erste Schicht aufgebrachten zweiten Schicht aus dem Benetzungsmittel und einer auf die Benetzungsmittel-Schicht aufgebrachten dritten Schicht aus einem Klebemittel, insbesondere einem Acrylat-Kleber. Hierbei ist die zweite Schicht z.B. durch Aufwalzen von 0,05 g Titan und/oder Titandiborid und 0,03-0,05 g, vorzugsweise 0,05 g, Zinn auf der Oberfläche der ersten Schicht fixiert, wobei die Klebemittel-Schicht 0,02-0,06 mm, insbesondere 0,03 mm, dick ist, und wobei die Gesamtdicke des Haftetiketts 0,1-4 mm, vorzugsweise 0,10-0,16 mm, insbesondere 0,13 mm, oder 0,25-0,35 mm, beträgt. Vorzugsweise ist dem Benetzungsmittel und/oder dem Klebemittel Zinnpulver, vorzugsweise mit einer maximalen Korngröße von 0,02-0,06 mm, insbesondere 0,045 mm, zugemischt.

Nach einer Ausführungsform der Erfindung ist das Klebemittel eine Klebeschicht, insbesondere aus Acrylat-Kleber, mit einer Dicke von 0,02-0,06 mm, insbesondere 0,03-0,05 mm, und die Gesamtdicke des Erstbenetzungshilfsmaterials beträgt 0,07-4 mm, vorzugsweise 0,07-0,16 mm, insbesondere 0,10-0,13 mm, oder 0,2-0,35 mm. Diese Dickenabmessungen haben sich als ausreichend hinsichtlich der gewünschten Verteilung und ausreichenden Ausbildung einer Aluminiumnitridschicht herausgestellt, wobei sich der Kleber ausreichend schnell, jedoch erst nach Einsetzen der Haftwirkung durch das flüssige Zinn zersetzt und verdampft, und wobei bis zum Einsetzen der Haftwirkung durch das Zinn eine ausreichend starke Haftwirkung durch das Klebemittel entfaltet wird.

Das Erstbenetzungshilfsmaterial wird gemäß der Erfindung ferner vorteilhaft als Informationsträger herangezogen, wofür es z.B. mit einer Prägung oder einem Aufdruck versehen ist. Hiermit können z.B. Eigenschaften, sonstige Kennzeichnungen, wie Werbung und Marken auf das Erstbenetzungshilfsmaterial angebracht werden. Zum Aufbringen einer Prägung eignen sich insbesondere die verfestigte Wachssuspension sowie die Aluminiumfolie bzw. das Aluminiumblech; letztere/letzteres ist auch insbesondere zum Aufbringen eines Aufdrucks geeignet.

Die Erfindung stellt ferner einen elektrisch, im direkten Stromdurchfluss beheizbaren Verdampferkörper bereit, insbesondere einen keramischen Verdampferkörper, der eine Verdampferfläche zum Betreiben in einer PVD-Metallisierungsanlage zum Verdampfen von Aluminium aufweist. Der Verdampferkörper enthält als Materialkomponente Stickstoff, insbesondere in Form von Bornitrid, und ist mit einem auf der Verdampferfläche aufgebrachten, insbesondere vollflächig aufgebrachten, erfindungsgemäßen Erstbenetzungshilfsmaterial versehen.

Der Verdampferkörper ist wie oben bereits kurz angesprochen bevorzugt eine Mischkeramik mit den Hauptkomponenten Titandiborid und Bornitrid, wobei ein Mischungsverhältnis von je 50 Gew.% plus/minus 10 Gew.% vorliegt. Der Verdampferkörper kann gemäß der Erfindung eine Kavität aufweisen, in welche die suspensionsartige, pulverförmige oder folienförmige Erstbenetzungshilfsschicht eingebracht ist, die vorzugsweise mit einer abnehmbaren oder wärmeempfindlichen Abdeckung abgedeckt ist.

Der Verdampferkörper weist eine Verdampfungsfläche auf. Die Verdampferfläche kann vorzugsweise vollflächig oder auch teilflächig mit einem Erstbenetzungshilfsmaterial gemäß der Erfindung belegt sein.

Nach einer bevorzugten Ausführungsform beträgt die auf die Verdampferfläche des Verdampferkörpers bezogene eingesetzte Masse an Benetzungsmittel 0,3 bis 400 mg/cm²_{Verdampferfläche}, vorzugsweise 1 bis 6 mg/cm²_{Verdampferfläche}, und beträgt die des Aluminiums 0,1 bis 100 mg/cm²_{Verdampferfläche}, vorzugsweise 10 bis 60 mg/cm²_{Verdampferfläche}.

Die Erfindung stellt ferner ein Verfahren zum Herrichten eines Verdampferkörpers bereit, insbesondere eines im direkten Stromdurchfluss beheizbaren keramischen Verdampferkörpers, der zum Betreiben in einer PVD-Metallisierungsanlage zum Verdampfen von Aluminium vorgesehen ist und Stickstoff, insbesondere in Form von Bornitrid, als Materialkomponente enthält. Dabei wird ein erfindungsgemäßes Erstbenetzungshilfsmaterial zumindest teilflächig, insbesondere im wesentlichen ganzflächig, auf die Verdampferfläche des Verdampferkörpers vor dessen Erwärmung aufgebracht. Im Einsatz wird der Verdampferkörper gemäß der Erfindung dann mit elektrischem Strom betrieben, um das Aluminium des Erstbenetzungshilfsmaterials zu schmelzen und mittels des Benetzungsmittels großflächig auf der Verdampferfläche zu verteilen, wodurch das Aluminium des geschmolzenen Erstbenetzungshilfsmaterials mit der Stickstoffkomponente des Verdampferkörpers unter Ausbildung einer Aluminiumnitridschicht reagiert, auf welche dann das eigentlich zu verdampfende Aluminiummaterial aufgebracht wird.

Nach obigem Verfahren wird das Erstbenetzungshilfsmaterial vorzugsweise in Form einer Suspension in eine Kavität des Verdampferkörpers hinein eingebracht. Auch kann die Suspension auf die Verdampferfläche des Verdampferkörpers mit einer Schichtdicke von 0,05-2,0 mm, insbesondere 0,1-0,2 mm, aufgebracht werden. Vorzugsweise wird eine Suspension mit einem über einer Temperatur von 70°C liegendem Schmelzpunkt verwendet, so dass die Suspension nach dem Aufbringen auf die Verdampferfläche des Verdampferkörpers bzw. nach dem Einbringen in die Kavität des Verdampferkörpers durch Abkühlen verfestigt werden kann. Dies ermöglicht das Vorsehen einer Prägung auf der Oberfläche der Wachsschicht zur Übermittlung von Informationen und gestattet ein problemloses Ausliefern/Versenden des mit dem Erstbenetzungshilfsmaterial ausgestatteten Verdampferkörpers.

Die Erfindung wird im Folgenden anhand bevorzugter Ausführungsformen mit Bezugnahme auf die Zeichnung erläutert. In der Zeichnung zeigen:
Figur 1 eine perspektivische Ansicht eines Verdampferkörpers mit einem Erstbenetzungshilfsmaterial gemäß einer ersten Ausführungsform der Erfindung,
Figur 2 eine Querschnittsansicht eines Verdampferkörpers mit einem Erstbenetzungshilfsmaterial gemäß der ersten Ausführungsform der Erfindung,
Figur 3 eine perspektivische Ansicht eines Verdampferkörpers mit einem Erstbenetzungshilfsmaterial gemäß einer anderen Ausführungsform der Erfindung,
Figur 4 eine Querschnittsansicht eines Verdampferkörpers mit einem Erstbenetzungshilfsmaterial gemäß der in Fig. 3 gezeigten Ausführungsform der Erfindung,
Figur 5 eine perspektivische Ansicht eines Verdampferkörpers mit einem Erstbenetzungshilfsmaterial gemäß einer noch anderen Ausführungsform der Erfindung,
Figur 6 eine Querschnittsansicht eines Verdampferkörpers mit einem Erstbenetzungshilfsmaterial gemäß der in Fig. 5 gezeigten Ausführungsform der Erfindung, und
Figur 7 eine perspektivische Ansicht eines Verdampferkörpers mit einem Erstbenetzungshilfsmaterial.

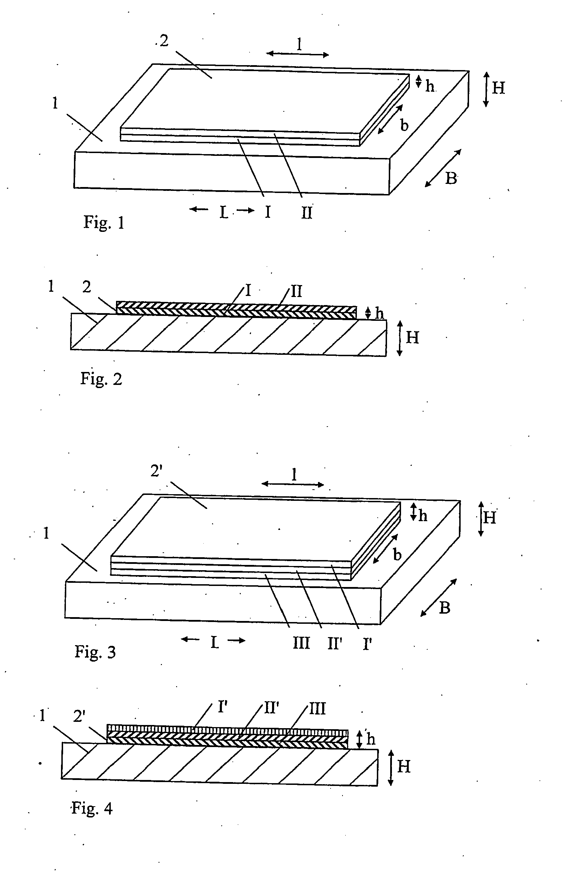

Fig. 1 und Fig. 2 zeigen einen Verdampferkörper 1 mit einem Erstbenetzungshilfsmaterial gemäß einer ersten Ausführungsform der Erfindung. Der Verdampferkörper 1 ist in Form eines sog. Verdampferschiffchens ausgebildet und besteht aus heißgepresstem keramischem Material, das als Hauptkomponente Titandiborid und Bornitrid enthält, wobei Titandiborid die elektrisch leitfähige Komponente und Bornitrid die elektrisch isolierende Komponente ist. Das Mischungsverhältnis von leitfähiger zu nichtleitfähiger Komponente liegt bei je 50 Gew.% (+/- 10 Gew.%), woraus sich ein spezifischer Widerstand von ca. 600-6000 µOhm*cm ergibt. Der Verdampferkörper 1 weist z.B. eine Länge L von ca. 130 mm, eine Breite B von ca. 30 mm und eine Höhe H von ca. 10 mm auf.

Vorzugsweise wird der Verdampferkörper direkt, d.h. im direkten Stromdurchfluss, widerstandsbeheizt. Er kann jedoch auch indirekt, d.h. mittels einer externen Heizquelle, beheizt werden.

Das Erstbenetzungshilfsmaterial gemäß der ersten Ausführungsform der Erfindung ist als Mehrschichtstruktur ausgebildet und auf die die Verdampferfläche bildende obere Fläche des Verdampferkörpers 1 aufgebracht. Das Erstbenetzungshilfsmaterial weist eine Länge 1 von etwa 100 mm, eine Breite b von etwa 28 mm und eine Höhe h von 0,105-0,4 mm auf. Die in Fig. 1 und Fig. 2 gezeigte Mehrschichtstruktur ist eine Dualschicht 2 mit einer ersten Schicht I und einer zweiten Schicht II.

Die erste Schicht I der Dualschicht 2 ist als Haftschicht ausgebildet und besteht aus einer 0,02-0,06 mm, bevorzugt 0,03-0,05 mm, dicken Klebemittel-Schicht, welcher Titanund oder Titandiboridpulver mit einem Gewichtanteil von 15-40 Gew.%, insbesondere 30 Gew.%, zugemischt ist. Das Titanund/oder Titandiboridpulver hat eine maximale Korngröße von 0,01-0,02 mm, insbesondere 0,015 mm. Vorzugsweise ist der Haftschicht zusätzlich Zinnpulver mit einem Gewichtanteil von 5-30 Gew.%, insbesondere 30 Gew.% zugemischt, wobei das Zinnpulver eine maximale Korngröße von 0,06 mm, insbesondere 0,045 mm, aufweist. Das Titan- und/oder Titandiboridpulver dient als Benetzungsmittel, wobei alternativ Zirkoniumdiborid, Zirkonium, Titandisilizid, Zirkoniumdisilizid, Molybdändisilizid, Molybdän oder Ferrosiliziumdititanat (FeSiTi₂) als Benetzungsmittel verwendet und der Klebemittel-Schicht beigemischt werden können. Als Klebemittel wird hier organischer Acrylat-Kleber verwendet, wobei die Erfindung nicht auf die Verwendung von organischem Acrylat-Kleber als Klebemittel begrenzt ist. Das Zinn fungiert bei Temperaturen über 230°C unter Ausbildung einer Schmelze als "Haftmittel" und ersetzt so bei erhöhten Temperaturen das Klebemittel, welches bei ca. 250°C verdampft. Der Dampfdruck des Zinns und des Aluminiums sind in etwa gleich, so dass das Zinn vollständig, d.h. rückstandslos, verdampft wird.

Die zweite Schicht II der Dualschicht 2 weist eine Dicke von 0,045-4 mm, vorzugsweise 0,045-0,1 mm, insbesondere 0,055 mm, oder 0,2-0,3 mm, insbesondere 0,24-0,26 mm, auf und enthält als Hauptkomponente Aluminium. Das Aluminium ist dabei vorzugsweise in Form einer Aluminiumfolie oder eines Aluminiumblechs mit einer Länge von 100 mm und einer Breite von 28 mm vorgesehen, kann jedoch auch in Form einer Folie bzw. eines Blechs aus einer Aluminiumlegierung ausgebildet sein, welche/welches neben dem zu etwa 90-97 Gew.% enthaltenen Aluminium das Benetzungsmittel, z.B. Titan, zu etwa 3-10 Gew.% enthält. Auch kann der Legierung Zinn als Legierungsbestandteil zulegiert sein.

Das Erstbenetzungshilfsmaterial gemäß der ersten Ausführungsform der Erfindung ist mittels der als Haftschicht ausgebildeten ersten Schicht I wie ein Haftetikett auf der die Verdampferfläche bildenden Oberfläche des Verdampferkörpers 1 aufgeklebt. Vorzugsweise ist das Erstbenetzungshilfsmaterial großflächig, zentral auf der Oberfläche des Verdampferkörpers 1 angebracht, so dass ein seitliches Herunterfließen des geschmolzenen Aluminiums bzw. des Benetzungsmittels vermieden bzw. reduziert wird. Das Klebemittel der ersten Schicht I, mittels dessen das Erstbenetzungshilfsmaterial wie ein Haftetikett auf den Verdampferkörper 1 aufgebracht ist, ist insbesondere derart gewählt, dass es sich beim Erhitzen des Verdampferkörpers 1 zersetzt und komplett, d.h. annähernd rückstandslos, verdampft, wobei die Zersetzungstemperatur des Klebemittels vorzugsweise bei ca. 250°C oder höher liegt. Kurz vor der Zersetzung des Klebemittels, beginnt das Zinn zu schmelzen und übernimmt die Haftwirkung des Klebemittels. Dies ist insbesondere dann wichtig, wenn die zweite Schicht II der Dualschicht 2 als Folie/Blech oder pulverförmig ausgebildet ist. Dann wird durch die Zinnschmelze verhindert, dass die Folie bzw. das Blech oder einzelne Pulverpartikel durch aufsteigende Gasblasen des sich zersetzenden Klebemittels angehoben bzw. mitgerissen werden. Entscheidend ist dabei, dass das Zinn bereits vor der Zersetzungstemperatur des Klebemittels seine Haftwirkung voll entfaltet. Zusätzlich oder alternativ kann eine perforierte Folie bzw. ein perforiertes Blech vorgesehen sein, so dass der verdampfende Kleber entweichen kann, ohne die Folie anzuheben.

Der Verdampferkörper 1 mit der auf seiner Oberfläche bzw. Verdampferfläche aufgebrachten Dualschicht 2 wird dann in einer Metallisierungsanlage unter Hochvakuum vorzugsweise widerstandsbeheizt und auf eine Temperatur von ca. 1450 bis 1600°C gebracht. Zu Beginn des Aufheizvorgangs zersetzt sich der Acrylat-Kleber der ersten Schicht I des Erstbenetzungshilfsmaterials, und dann beginnt das Aluminium der zweiten Schicht II des Erstbenetzungshilfsmaterials zu schmelzen. Das flüssige Aluminium wird durch das Benetzungsmittel, hier Titan und/oder Titandiborid, aufgrund des geringen Benetzungswinkels gegenüber der Verdampferfläche des Verdampferkörpers 1 gleichmäßig auf dieser verteilt und kann damit über die ganze, zuvor beklebte Verdampferfläche In-Situ mit dem Bornitrid des Verdampferkörpers 1 zu Aluminiumnitrid reagieren. Der Vorteil der Aluminiumnitridbildung während des Aufheizvorgangs liegt darin begründet, dass das Aluminiumnitrid von Aluminium deutlich besser benetzt wird als das Bornitrid des Verdampferkörpers 1. Am Ende des Aufheizvorgangs wird auch der Dampfdruck des Aluminiums erreicht, d.h. der Dampfdruck des Aluminiums ist gleich oder größer dem Druck aus der Gasphase, so dass das Aluminium verdampft. Von dem eingangs aufgebrachten Erstbenetzungshilfsmaterial bleibt dann nur noch Titan/Titandiborid auf der Verdampferfläche des Verdampferkörpers 1 zurück.

Auf die beim Aufheizvorgang generierte Aluminiumnitridschicht und den Titan/Titandiborid-Rückstand des Erstbenetzungshilfsmaterials wird nun kontinuierlich Aluminium, z.B. in Form eines Aluminiumdrahtes, zugeführt. Aufgrund der Aluminiumnitridschicht wird das kontinuierlich zugeführte Aluminium gleichmäßig auf der Verdampferfläche des Verdampferkörpers 1 verteilt, wobei etwa 80% der mit dem als Dualschicht 2 ausgebildeten Erstbenetzungshilfsmaterial beklebten Oberfläche des Verdampferkörpers 1 mit Aluminium benetzt ist. Hierdurch ergibt sich bereits zu Beginn eine hohe anfängliche Abdampfrate, und die anfängliche Abdampfrate muss nicht geringer als die gewünschte Zielabdampfrate eingestellt werden. Das Benetzungsmittel, hier Titan/Titandiborid, wird nicht verdampft und bleibt somit auf der Verdampferfläche des Verdampferkörpers 1 als Rückstand zurück. Weitere Vorteile, die sich durch eine verbesserte Erstbenetzung des Aluminiums auf dem keramischen Verdampferkörper 1 ergeben, sind eine Reduzierung der anfänglichen thermischen Belastung auf den Verdampferkörper 1 und eine größere und gleichmäßige Benetzungsfläche auch über die Erstbenetzungsphase hinaus, wodurch die Standzeit des Verdampferkörpers 1 erhöht wird und die elektrische Kontrolle des Verdampferkörpers 1 verbessert wird.

Fig. 3 und Fig. 4 zeigen eine zweite Ausführungsform der Erfindung. Der gezeigte Verdampferkörper 1 entspricht dem zuvor beschriebenen, in Fig. 1 dargestellten Verdampferkörper, d.h. Abmessungen und Zusammensetzung des Verdampferkörpers aus Fig. 1 und Fig. 3 sind identisch, weshalb sie mit denselben Bezugszeichen bezeichnet sind.

Gemäß der zweiten Ausführungsform der Erfindung ist ein Erstbenetzungshilfsmaterial, welches erneut als Mehrschichtstruktur ausgebildet ist, auf der die Verdampferfläche bildenden oberen Fläche des Verdampferkörpers 1 aufgebracht. Das Erstbenetzungshilfsmaterial gemäß der zweiten Ausführungsform der Erfindung weist vorzugsweise eine Länge 1 von etwa 100 mm, eine Breite b von etwa 28 mm und eine Höhe h von etwa 0,1 mm bis 4 mm auf und ist eine Dreifachschicht 2' mit einer ersten Schicht I', einer zweiten Schicht II' und einer dritten Schicht III.

Die erste Schicht I' der Dreifachschicht 2' enthält als Hauptkomponente Aluminium, wobei das Aluminium vorzugsweise in Form einer Aluminiumfolie bzw. eines Aluminiumblechs vorgesehen ist, jedoch auch in Form einer Folie bzw. eines Blechs aus einer Aluminiumlegierung ausgebildet sein kann, welche neben dem zu etwa 90-97 Gew.% enthaltenen Aluminium ein Benetzungsmittel, z.B. Titan, zu etwa 3-10 Gew.% enthält. Auch kann der Folie neben dem Benetzungsmittel zusätzlich Zinn zulegiert sein, welches wie oben beschrieben als Haftmittel für Temperaturen über 230°C dient.

Die zweite Schicht II' besteht aus einem Benetzungsmittel, hier Titan und/oder Titandiborid, welches pulverförmig bereitgestellt und auf die erste Schicht I' aufgebracht ist. Vorzugsweise ist das Benetzungsmittel auf die erste Schicht I' aufgewalzt, um es an der ersten Schicht I' zu fixieren bzw. die erste Schicht I' mit dem Benetzungsmittel zu überziehen. Insgesamt 0,05 g Titan und/oder Titandiborid sind durch Aufwalzen auf der Oberfläche der ersten Schicht I' fixiert. Alternativ können Zirkoniumdiborid, Zirkonium, Titandisilizid, Molybdän, Ferrosiliziumdititanat (FeSiTi₂), Molybdändisilizid oder Zirloniumdisilizid als Benetzungsmittel verwendet werden.

Die dritte Schicht III der Dreifachschicht 2' ist als eine Haftschicht ausgebildet und besteht aus einer 0,02 bis 0,06 mm, bevorzugt 0,03 mm, dicken Klebemittel-Schicht, die unterhalb der ersten Schicht I' und der zweiten Schicht II' angeordnet ist, wobei die Gesamtdicke des Erstbenetzungshilfsmaterials 0,1-4 mm, vorzugsweise 0,10-0,16 mm, insbesondere 0,13 mm, oder 0,25-0,35 mm beträgt. Als Klebemittel wird hier organischer Acrylat-Kleber verwendet, wobei die Erfindung nicht auf die Verwendung von organischem Acrylat-Kleber als Klebemittel begrenzt ist.

Vorzugsweise ist dem Benetzungsmittel und/oder dem Klebemittel Zinnpulver mit einer maximalen Korngröße von 0,02 bis 0,06 mm zugemischt. So können z.B. 0,05 g Titan/Titandiborid und 0,05 g Zinn vermischt werden und durch Aufwalzen oder ein anderes Verfahren auf die erste Schicht I' aufgebracht werden.

Das Erstbenetzungshilfsmaterial gemäß der zweiten Ausführungsform der Erfindung ist mittels der als Haftschicht ausgebildeten dritten Schicht III wie ein Haftetikett auf der Oberfläche des Verdampferkörpers 1 aufgeklebt. Das Klebemittel der dritten Schicht III ist derart gewählt, dass es sich beim Erhitzen des Verdampferkörpers 1 zersetzt und komplett, d.h. annähernd rückstandslos, verdampft, wobei bei Temperaturen über 230°C das Zinn die Haftwirkung des Klebemittels ersetzt. Der Verdampferkörper 1 mit dem aufgeklebten Erstbenetzungshilfsmaterial wird wie oben beschrieben in einer Metallisierungsanlage unter Hochvakuum vorzugsweise widerstandsbeheizt und somit auf eine Temperatur von ca. 1450 bis 1600°C gebracht. Der Aufheizvorgang und das Ergebnis sind entsprechend der Beschreibung der ersten Ausführungsform der Erfindung.

Zudem ist es möglich die dritte Schicht III der Dreifachschicht 2' wegzulassen, und stattdessen das Erstbenetzungshilfsmaterial auf den Verdampferkörper 1, insbesondere in eine an der Oberseite des Verdampferkörpers 1 ausgebildete Kavität hinein, zu legen, anstatt es auf den Verdampferkörper 1 aufzukleben.

Ferner, alternativ zu der Aluminiumfolie/dem Aluminiumblech oder der Aluminiumlegierungs-Folie/dem Aluminiumlegierungs-Blech kann auch ein Stück Aluminiumdraht verwendet werden, der mit dem Benetzungsmittel, vorzugsweise Titan und/oder Titandiborid, überzogen wird und auf die Verdampferfläche des Verdampferkörpers 1, insbesondere in eine an der Oberseite des Verdampferkörpers 1 ausgebildete Kavität hinein, gelegt wird und/oder mittels eines Klebemittels auf die Verdampferfläche des Verdampferkörpers 1 aufgeklebt wird. Vorzugsweise ist der Aluminiumdraht meanderförmig gebogen und auf die Verdampferfläche aufgelegt, so dass er einen möglichst großen Teil der Verdampferfläche einnimmt bzw. abdeckt. Jedoch kann die Verdampferfläche auch so nicht vollständig mit dem Erstbenetzungshilfsmaterial bedeckt werden, so dass hinsichtlich des Aspekts einer möglichst schnellen, großflächigen Erstbenetzung bzw. Beschichtung der Verdampferfläche die Ausbildung des Erstbenetzungshilfsmaterials als Haftetikett nach der ersten bzw. der zweiten Ausführungsform der Erfindung dieser Variante vorzuziehen ist.

Gemäß einer dritten, nicht dargestellten Ausführungsform der Erfindung ist ein Erstbenetzungshilfsmaterial vorgesehen, welches in Form eines Haftetiketts ausgebildet ist und auf die Oberfläche bzw. die Verdampferfläche des Verdampferkörpers aufgeklebt ist. Der zu verwendende Verdampferkörper entspricht dem oben beschriebenen Verdampferkörper. Das Erstbenetzungshilfsmaterial gemäß der dritten Ausführungsform der Erfindung hat vorzugsweise eine Länge von ca. 100 mm, eine Breite von ca. 28 mm und eine Höhe von ca. 0,1-4 mm und ist ähnlich der ersten Ausführungsform der Erfindung als Dualschicht mit einer ersten Schicht und einer zweiten Schicht ausgebildet.

Die erste Schicht des Erstbenetzungshilfsmaterials gemäß der dritten Ausführungsform der Erfindung ist eine 0,02-0,06 mm, insbesondere 0,03 mm, dicke Haftschicht aus organischem Acrylat-Kleber, wobei die Erfindung nicht auf den Einsatz von Acrylat-Klebstoff begrenzt ist. Wie oben beschrieben ist das Klebemittel derart ausgewählt, dass es sich beim Erhitzen des Verdampferkörpers zersetzt und komplett, d.h. annähernd rückstandslos, verdampft. Wie oben beschrieben kann dem Klebemittel zudem Zinn beigemischt sein.

Die zweite Schicht des Erstbenetzungshilfsmaterials gemäß der dritten Ausführungsform der Erfindung weist Aluminium in Form einer Folie oder eines Aluminiumblechs aus einer Aluminiumlegierung auf, welche neben dem Aluminium ein Benetzungsmittel als Legierungsbestandteil aufweist, wobei die Aluminium-Benetzungsmittel-Legierung 90-97 Gew.% metallisches Aluminium, inklusive Verunreinigungen, und 3-10 Gew.% Benetzungsmittel aufweist. Das Benetzungsmittel ist vorzugsweise Titan, welches dem Aluminium zulegiert ist, jedoch kann dem Aluminium auch ein anderes Benetzungsmittel, z.B. Zirkonium, zulegiert sein. Ferner kann dem Aluminium auch Zinn als weiterer Legierungsbestandteil zulegiert sein.

Der mit dem Erstbenetzungshilfsmaterial gemäß der dritten Ausführungsform der Erfindung ausgestattete Verdampferkörper wird in einer Metallisierungsanlage unter Hochvakuum vorzugsweise widerstandsbeheizt auf eine Temperatur von ca. 1450-1600°C gebracht. Der Aufheizvorgang und das Ergebnis sind entsprechend der Beschreibung der ersten Ausführungsform der Erfindung.

Alternativ kann gemäß einer vierten, nicht dargestellten Ausbildungsform der Erfindung ein Materialstück, z.B. ein Drahtmaterialstück, ein Materialwürfel oder linsenförmig gepresstes Material, aus einer Aluminiumlegierung, welche neben Aluminium ein Benetzungsmittel als Legierungsbestandteil enthält, vorgesehen sein und entweder mittels einer Haft- bzw. Klebemittel-Schicht auf die Verdampferfläche des Verdampferkörpers aufgeklebt sein und/oder in eine an der Oberfläche des Verdampferkörpers ausgebildete Kavität hinein eingebracht sein. Dabei ist das Materialstück vorzugsweise derart ausgebildet und auf die Verdampferfläche aufgebracht, dass es einen möglichst großen Teil der Verdampferfläche abdeckt. Ferner kann dem Aluminium auch Zinn als weiterer Legierungsbestandteil zulegiert sein.

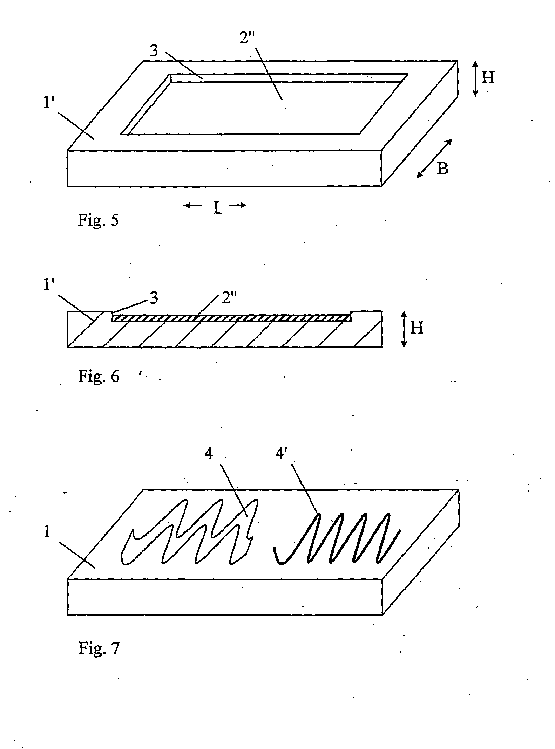

Fig. 5 und Fig. 6 zeigen eine fünfte Ausführungsform der Erfindung mit einem Verdampferkörper 1'. Hinsichtlich der Abmessungen und seiner Zusammensetzung entspricht der Verdampferkörper 1' dem zuvor beschriebenen Verdampferkörper 1, jedoch weist der Verdampferkörper 1' an seiner die Verdampferfläche bildenden Oberfläche eine Kavität 3 auf. Die Kavität 3 hat z.B. eine Länge von ca. 100 mm, eine Breite von ca. 26 mm und eine Höhe von ca. 1 mm. Die Kavität 3 in Fig. 5 und Fig. 6 weist einen rechteckigen Querschnitt auf, jedoch kann die Kavität 3 auch eine andere Querschnittsform, z.B. einen kreisrunden Querschnitt aufweisen. Ebenso können die Begrenzungsflächen der Kavität 3, hier jeweils als ebene und senkrechte Begrenzungsfläche dargestellt, als geneigte oder gekrümmte Begrenzungsflächen ausgebildet sein, so dass Rückstande in der Kavität bzw. von dem Verdampferkörper.problemlos entfernt werden können.

Gemäß der fünften Ausführungsform der Erfindung wird das Erstbenetzungshilfsmaterial in Form einer Suspension 2" bereitgestellt, vorzugsweise in Form einer 150°C heißen Wachssuspension, welche in die Kavität 3 des Verdampferkörpers 1' hinein gefüllt wird, wobei ein pulverförmiges Gemisch aus Aluminium und einem Benetzungsmittel in der Suspension 2" enthalten sind. Die Suspension 2" enthält z.B. 95-105 g, vorzugsweise 100 g, Paraffin-Stearat-Wachs als eine organische Matrix (z.B. Wachs oder Kleber), in welches zwischen 1,5 und 2,5 g, vorzugsweise 2,0 g, Titan und/oder Titandiboridpulver mit einer maximalen Korngröße von 0,01-0,02 mm, vorzugsweise 0,015 mm, und 10-20 g, vorzugsweise 15 g Aluminiumpulver mit einer maximalen Korngröße von 0,4-0,6 mm, vorzugsweise 0,5 mm eingerührt werden, vorzugsweise bei einer Temperatur von 150°C, so dass das Gemisch aus Benetzungsmittel und Aluminium in der Suspension 2" fein verteilt ist bzw. in der organischen Matrix eingebunden ist. Vorzugsweise ist der Suspension 2" zudem Zinn beigemischt.

Der Verdampferkörper 1' wird wie oben beschrieben in einer Metallisierungsanlage auf eine Temperatur von 1450-1600°C erhitzt. Zu Beginn des Aufheizvorgangs verdampft die organische Matrix, hier das Wachs, und das Gemisch aus Benetzungsmittel und Aluminium und gegebenenfalls Zinn bleibt in der Kavität 3 des Verdampferkörpers 1' zurück. Die weiteren Vorgänge während des Aufheizvorgangs und das Ergebnis davon entsprechen dem für die erste Ausführungsform der Erfindung beschriebenen Aufheizvorgang.

Gemäß einer sechsten, nicht dargestellten Ausführungsform der Erfindung wird eine Suspension aus Glykol, organischem Klebstoff, Titan/Titandiboridpulver und Aluminiumpulver mit einer Schichtdicke von 0,01-2 mm, insbesondere 0,1-0,2 mm, als ein Erstbenetzungshilfsmaterial auf die Verdampferfläche des Verdampferkörpers aufgetragen. Der Verdampferkörper entspricht vorzugsweise dem in der ersten Ausführungsform der Erfindung verwendeten Verdampferkörper, er kann jedoch auch eine Kavität gemäß dem Verdampferkörper 1' aufweisen. 100 g Suspension enthalten 50 g Aluminiumpulver (d90<0,05 mm), 7 g Titan/Titandiboridpulver (d90<13 mm), 5 g Zucker und 38 g Glykol. Vorzugsweise ist in der Suspension zudem Zinnpulver enthalten.

Somit kann das Erstbenetzungshilfsmaterial gemäß der sechsten Ausführungsform der Erfindung mittels einfachen Aufstreichens auf dem Verdampferkörper aufgebracht werden. Alternativ kann die Suspension in die an der Verdampferfläche des Verdampferkörpers ausgebildete Kavität hinein eingebracht werden.

Fig. 7 zeigt eine siebte Ausführungsform der Erfindung, gemäß welcher das Aluminium des Erstbenetzungshilfsmaterials in Form eines Aluminiumstücks vorgesehen ist, insbesondere in Form eines Aluminiumbandstücks 4 oder eines Aluminiumdrahtstücks 4', welche vorzugsweise meanderförmig gebogen sind, wobei das Aluminiumstück neben Aluminium noch das Benetzungsmittel als Bestandteil aufweist, wobei das Benetzungsmittel ein nicht mit Aluminium legierbares Material ist. Ferner kann dem Aluminium Zinn als Legierungsbestandteil zulegiert sein. Das Benetzungsmittel, z.B. Titandiboridpulver, wird dem Aluminiumstück zugemischt, welches, wie in Fig. 7 gezeigt, einfach lose auf die Verdampferfläche des Verdampferkörpers 1 aufgelegt wird oder zum besseren Halt in eine an der Verdampferfläche des Verdampferkörpers 1 ausgebildete Kavität hinein gelegt werden kann. Alternativ kann das Gemisch aus Aluminiumstück und Benetzungsmittel mittels eines Klebers, dem vorzugsweise Zinn beigemischt ist, auf die Verdampferfläche des Verdampferkörpers 1 aufgeklebt werden. Auch hier ist das Aluminiumstück vorzugsweise derart auf der Verdampferfläche aufgebracht, dass es einen möglichst großen Teil der Verdampferfläche einnimmt bzw. abdeckt, jedoch kann die Verdampferfläche des Verdampferkörpers mit dieser Ausführungsform im Gegensatz zu denjenigen Ausführungsformen, in welchen das Erstbenetzungshilfsmaterial als Haftetikett oder Suspension auf die Verdampferfläche aufgebracht ist, nicht vollständig mit dem Erstbenetzungshilfsmaterial bedeckt werden.

Für die oben beschriebenen Ausführungsformen 2 bis 7 gilt, dass das Erstbenetzungshilfsmaterial mittels einer Haft- bzw. Klebemittel-Schicht auf der Verdampferfläche des Verdampferkörpers aufgebracht sein kann und/oder in eine an der Oberfläche des Verdampfers ausgebildete Kavität eingebracht sein kann. Des Weiteren ist die Wahl des Benetzungsmittels nicht auf Titandiborid und Titan beschränkt. Metalllegierungen, welche Zirkonium und/oder Molybdän und/oder Titan enthalten, Zirkonium, Zirkoniumdiborid, Titandisilizid, Molybdän, Zirkoniumdisilizid, Molybdändisilizid, Ferrosiliziumdititanat (FeSiTi₂) sind weitere Benetzungsmittel, die eingesetzt werden können. Generell gilt, dass das Benetzungsmittel mindestens 30 Gew.%, vorzugsweise 40 Gew%, Zirkonium, Molybdän, Titan oder eine Kombination davon als Materialkomponente enthält. Die genannten Komponenten können elementar, als Metalllegierung oder in gebundener Form, wie z.B. als Borid oder Silizid, vorliegen. Zudem können die Komponenten als Nitride, Carbonate oder Carbonitride vorliegen. Oxide der Metalle sind nicht geeignet. Dabei gilt, dass die Verbindungen in der Lage sind unter den in der Metallisierungsanlage gegebenen Aufheizbedingungen im Kontakt mit flüssigem Aluminium freies Titanmetall/Molybdänmetall/Zirkoniummetall bilden. Wenn als Pulver eingesetzt, wird das Benetzungsmittel generell mit einer Korngröße von 0-0,2 mm bereitgestellt. Die Aluminiumquelle kann eine Aluminiumfolie bzw. ein Aluminiumblech mit einer Dicke von 0,01-4 mm, vorzugsweise eine 0,01 bis 0,1 mm dicke Aluminiumfolie oder ein 0,2-0,3 mm dickes Aluminiumblech, Aluminiumpulver mit einer Korngröße kleiner gleich 0,5 mm oder ein Aluminiumstück sein. Die eingesetzte, auf die Verdampferfläche des Verdampferkörpers bezogene Masse an Benetzungsmittel beträgt 0,3 bis 400 mg/cm²_{Verdampferfläche}, vorzugsweise 1 bis 6 mg/cm²_{Verdampferfläche}, und die des Aluminiums beträgt 0,1 bis 100 mg/cm²_{Verdampferfläche}, vorzugsweise 10 bis 60 mg/cm²_{Verdampferfläche}.

Zudem kann das erfindungsgemäße Erstbenetzungshilfsmaterial vorteilhaft als Informationsträger herangezogen werden, wobei z.B. Eigenschaften, Kennzeichnungen oder auch Werbung und Marken auf dem Erstbenetzungshilfsmaterial angebracht werden können. Dies kommt vor allem in denjenigen Ausführungsformen zur Geltung, in denen die oberste Schicht des Erstbenetzungshilfsmaterials eine Aluminiumfolie/ein Aluminiumblech ist, welche/welches bedruckt oder geprägt ist. Liegt ein in Wachs dispergiertes Pulvergemisch aus Aluminium und Benetzungsmittel vor, so kann das Wachs geprägt werden.

## Patentansprüche (Patentansprüche für folgende(n) Vertragsstaat(en): AT,BE,BG,CH,CY,CZ,DK,EE,ES,FI,FR,GB,GR,HU,IE,IS,IT,LI,LT,LU,LV,MC,NL,PL,PT,RO,SE,SI,SK,TR)

1. Erstbenetzungshilfsmaterial zum Aufbringen auf die Verdampferfläche eines elektrisch beheizbaren keramischen Verdampferkörpers (1), welcher zum Betreiben in einer PVD-Metallisierungsanlage zum Verdampfen von Aluminium vorgesehen ist und Stickstoff, insbesondere in Form von Bornitrid, als Materialkomponente enthält, aufweisend in Form eines Schichtmaterials und/oder eines Pulvermaterials in trockener oder suspendierter Form:
wenigstens zwei Materialkomponenten, enthaltend:
Aluminium als erste Materialkomponente in derartiger Beschaffenheit, dass es nach dem Start des Betriebs des Verdampferkörpers (1) auf dessen Verdampferfläche bei der Erwärmung des Verdampferkörpers schmelzbar ist und fähig ist, im geschmolzenen Zustand mit dem Stickstoff des Verdampferkörpers (1) unter Ausbildung einer Aluminiumnitridschicht auf der Verdampferfläche zu reagieren, und
ein Benetzungsmittel als zweite Materialkomponente in derartiger Beschaffenheit, dass es fähig ist, eine gleichmäßige und großflächige Verteilung des geschmolzenen Aluminiums auf der Verdampferfläche zu begünstigen.

2. Erstbenetzungshilfsmaterial nach Anspruch 1, ferner aufweisend ein Klebemittel, mittels dessen das Erstbenetzungshilfsmaterial auf der Verdampferfläche klebehaftend anbringbar ist.

3. Erstbenetzungshilfsmaterial nach Anspruch 1 oder 2, ferner aufweisend die Materialkomponente Zinn, wobei das Zinn in elementarer oder in gebundener Form vorliegt.

4. Erstbenetzungshilfsmaterial nach einem der Ansprüche 1 bis 3, wobei das Benetzungsmittel mindestens 30 Gew.%, vorzugsweise mindestens 40 Gew.%, Zirkonium, Molybdän, Titan oder eine Kombination davon als Materialkomponente enthält, wobei die genannten Komponenten in elementarer Form oder gebunden, vorzugsweise als Borid oder Silizid, in dem Benetzungsmittel vorliegen.

5. Erstbenetzungshilfsmaterial nach einem der Ansprüche 1 bis 4, wobei das Benetzungsmittel Titandiborid, Titan, Zirkoniumdiborid, Zirkonium, Titandisilizid, Zirkoniumdisilizid, Molybdändisilizid, Molybdän oder Ferrosiliziumdititanat (FeSiTi₂) ist.

6. Erstbenetzungshilfsmaterial nach einem der Ansprüche 1 bis 5, wobei das Benetzungsmittel pulverförmig, insbesondere mit einer Korngröße von kleiner oder gleich 0,2 mm, ausgebildet ist.

7. Erstbenetzungshilfsmaterial nach Anspruch 3 und 6, wobei das Zinn in Pulverform mit einer maximalen Korngröße von 0,02 bis 0,06 mm, insbesondere 0,045 mm, bereitgestellt und dem Benetzungsmittel zugemischt ist.

8. Erstbenetzungshilfsmaterial nach einem der Ansprüche 1 bis 7, wobei das Aluminium pulverförmig, insbesondere mit einer Korngröße von kleiner oder gleich 0,5 mm, ausgebildet ist.

9. Erstbenetzungshilfsmaterial nach einem der Ansprüche 1 bis 7, wobei das Aluminium in Form einer Aluminiumfolie bzw. eines Aluminiumblechs mit einer Dicke von 0,01 mm bis 4 mm, insbesondere einer Aluminiumfolie mit einer Dicke von 0,01-0,1 mm oder eines Aluminiumblechs mit einer Dicke von 0,2-0,3 mm, ausgebildet ist.

10. Erstbenetzungshilfsmaterial nach den Ansprüchen 6 und 9, wobei das Benetzungsmittel auf die Aluminiumfolie bzw. das Aluminiumblech aufgewalzt ist.

11. Erstbenetzungshilfsmaterial nach den Ansprüchen 7 und 9, wobei das Gemisch aus Benetzungsmittel und Zinnpulver auf die Aluminiumfolie bzw. das Aluminiumblech aufgewalzt ist.

12. Erstbenetzungshilfsmaterial nach einem der Ansprüche 1 bis 5, wobei das Aluminium in Form einer Folie bzw. eines Blechs aus einer Aluminiumlegierung ausgebildet ist, welche neben dem Aluminium das Benetzungsmittel als Legierungsbestandteil enthält.

13. Erstbenetzungshilfsmaterial nach Anspruch 12, wobei die Legierung neben Aluminium und dem Benetzungsmittel als weiteren Legierungsbestandteil Zinn enthält.

14. Erstbenetzungshilfsmaterial nach den Ansprüchen 6 und 8, wobei das Aluminium und das Benetzungsmittel zu einem Pulvergemisch gemischt sind.

15. Erstbenetzungshilfsmaterial nach den Ansprüchen 7 und 8, wobei das Aluminium und das Gemisch aus Benetzungsmittel und Zinn zu einem Pulvergemisch gemischt sind.

16. Erstbenetzungshilfsmaterial nach Anspruch 14 oder 15, ausgebildet als eine Suspension aus flüssigem Klebemittel, insbesondere organischem Kleber oder Wachs, in welchem das Pulvergemisch dispergiert ist.

17. Erstbenetzungshilfsmaterial nach einem der Ansprüche 1 bis 7 und 9 ausgebildet als Dualschicht (2) mit einer ersten Schicht (I) aus einem Gemisch aus organischem Acrylat-Kleber und dem Benetzungsmittel und vorzugsweise Zinnpulver und mit einer zweiten Schicht (II) aus Aluminium oder einer Aluminiumlegierung, wobei die Dicke der zweiten Schicht (II) bevorzugt größer als die Dicke der ersten Schicht (I) ist.

18. Erstbenetzungshilfsmaterial nach Anspruch 17, wobei die erste Schicht (I) 0,02-0,06 mm, bevorzugt 0,05 mm, dick ist, wobei das Benetzungsmittel Titan- und/oder Titandiboridpulver mit einer maximalen Korngröße von 0,01-0,02 mm, insbesondere 0,015 mm, ist und mit einem Gewichtsanteil von 15-40 Gew.%, insbesondere 30 Gew.%, in der ersten Schicht (I) enthalten ist, und wobei das Zinnpulver mit einem Gewichtsanteil von 5-30 Gew.%, insbesondere 30 Gew.%, in der ersten Schicht enthalten ist, und wobei die Dicke der zweiten Schicht (II) 0,045-4 mm, vorzugsweise 0,045-0,1 mm, insbesondere 0,055 mm, oder 0,2-0,3 mm, insbesondere 0,24-0,26 mm, ist.

19. Erstbenetzungshilfsmaterial nach Anspruch 12, wobei die Aluminiumlegierung 90-97 Gew.% metallisches Aluminium, inklusive Verunreinigungen, und 3-10 Gew.% Titan als Benetzungsmittel aufweist.

20. Erstbenetzungshilfsmaterial nach einem der Ansprüche 1-11, ausgebildet als Dreifachschicht (2') mit einer von der Aluminiumfolie bzw. des Aluminiumblechs gebildeten ersten Schicht (I'), einer auf die erste Schicht (I') aufgebrachten zweiten Schicht (II') aus dem Benetzungsmittel und einer auf die Benetzungsmittel-Schicht aufgebrachten dritten Schicht (III) aus einem Klebemittel, insbesondere einem Acrylat-Kleber.

21. Erstbenetzungshilfsmaterial nach Anspruch 20, wobei die zweite Schicht (II') insbesondere durch Aufwalzen eines Gemischs aus 0,05 g Titan und/oder Titandiborid und 0,05 g Zinn auf der Oberfläche der ersten Schicht (I') fixiert ist, wobei die Klebemittel-Schicht 0,02-0,06 mm, insbesondere 0,03 mm, dick ist, und wobei die Gesamtdicke des Erstbenetzungshilfsmaterials 0,1-4 mm, vorzugsweise 0,10-0,16 mm, insbesondere 0,13 mm, oder 0,25-0,35 mm, beträgt.

22. Erstbenetzungshilfsmaterial nach Anspruch 20 oder 21, wobei dem Benetzungsmittel und/oder dem Klebemittel Zinnpulver, vorzugsweise mit einer maximalen Korngröße von 0,02 bis 0,06 mm, insbesondere 0,045 mm, zugemischt ist.

23. Erstbenetzungshilfsmaterial nach Anspruch 2, wobei das Klebemittel eine Klebeschicht, insbesondere aus einem Acrylat-Kleber, mit einer Dicke von 0,02-0,06 mm, insbesondere 0,03 mm, ist, und die Gesamtdicke des Erstbenetzungshilfsmaterials 0,07-4 mm, vorzugsweise 0,07-0,16 mm, insbesondere 0,10-0,13 mm, oder 0,02-0,035 mm, beträgt.

24. Erstbenetzungshilfsmaterial nach Anspruch 16, wobei die Suspension Parrafin-Stearat-Wachs, Titan- und/oder Titandiborid-Pulver mit einer maximalen Korngröße von 0,015 mm und Aluminiumpulver mit einer maximalen Korngröße von 0,5 mm aufweist.

25. Erstbenetzungshilfsmaterial nach Anspruch 16, wobei die Suspension Aluminiumpulver, Titan- und/oder TitandiboridPulver, Zucker und Glykol enthält.

26. Erstbenetzungshilfsmaterial nach Anspruch 9 oder 12, wobei die Folie bzw. das Blech mit einer Prägung oder einem Aufdruck versehen ist.

27. Elektrisch beheizbarer Verdampferkörper (1), insbesondere keramischer Verdampferkörper, der eine Verdampferfläche zum Betreiben in einer PVD-Metallisierungsanlage zum Verdampfen von Aluminium aufweist,
wobei der Verdampferkörper (1) Stickstoff, insbesondere in Form von Bornitrid, enthält und mit einem auf der Verdampferfläche aufgebrachten, insbesondere vollflächig aufgebrachten, Erstbenetzungshilfsmaterial nach einem der Ansprüche 1-26 versehen ist.

28. Verdampferkörper nach Anspruch 27, wobei der Verdampferkörper (1) eine Mischkeramik mit den Hauptkomponenten Titandiborid und Bornitrid ist, wobei ein Mischungsverhältnis von je 50 Gew.% plus/minus 10 Gew.% vorliegt.

29. Verdampferkörper nach Anspruch 27 oder 28, wobei die auf die Verdampferfläche des Verdampferkörpers (1) bezogene eingesetzte Masse an Benetzungsmittel 0,3 bis 400 mg/cm²_{Verdampferfläche}, vorzugsweise 1 bis 6 mg/cm²_{Verdampferfläche}, und die des Aluminiums 0,1 bis 100 mg/cm²_{Verdampferfläche}, vorzugsweise 10 bis 60 mg/cm²_{Verdampferfläche}, beträgt.

30. Verfahren zum Herrichten eines elektrisch beheizbaren Verdampferkörpers (1), insbesondere eines keramischen Verdampferkörpers (1), der zum Betreiben in einer PVD-Metallisierungsanlage zum Verdampfen von Aluminium vorgesehen ist und Stickstoff, insbesondere in Form von Bornitrid, als Materialkomponente enthält, wobei auf die Verdampferfläche des Verdampferkörpers (1) vor dessen Erwärmung ein Erstbenetzungshilfsmaterial nach einem der Ansprüche 1-26 zumindest teilflächig, insbesondere im wesentlichen ganzflächig, aufgebracht wird.

31. Verfahren nach Anspruch 30, bei welchem das Erstbenetzungshilfsmaterial in Form einer Suspension nach Anspruch 24 oder 25 in eine Kavität (3) des Verdampferkörpers (I') eingebracht wird.

32. Verfahren nach Anspruch 30, wobei die Suspension nach Anspruch 25 auf die Verdampferfläche des Verdampferkörpers (1) mit einer Schichtdicke von 0,05-2,0 mm, insbesondere 0,10-0,20 mm, aufgebracht wird.

33. Verfahren nach Anspruch 31 oder 32, wobei eine Suspension mit einem über einer Temperatur von 70°C liegendem Schmelzpunkt verwendet wird und die Suspension nach dem Aufbringen auf die Verdampferfläche des Verdampferkörpers (1) durch Abkühlen verfestigt und mit einer Prägung versehen wird.

## Patentansprüche (Patentansprüche für folgende(n) Vertragsstaat(en): DE)

1. Erstbenetzungshilfsmaterial zum Aufbringen auf die Verdampferfläche eines elektrisch beheizbaren keramischen Verdampferkörpers (1), welcher zum Betreiben in einer PVD-Metallisierungsanlage zum Verdampfen von Aluminium vorgesehen ist und Stickstoff, insbesondere in Form von Bornitrid, als Materialkomponente enthält, aufweisend ein Pulvergemisch mit:
pulverförmigem Aluminium mit einer Korngröße von kleiner oder gleich 0,6 mm, welches nach dem Start des Betriebs des Verdampferkörpers (1) auf dessen Verdampferfläche schmilzt und mit dem Stickstoff des Verdampferkörpers (1) unter Ausbildung einer Aluminiumnitridschicht auf der Verdampferfläche reagiert, und
pulverförmigem Benetzungsmittel, mittels dessen eine gleichmäßige und großflächige Verteilung des geschmolzenen Aluminiums auf der Verdampferfläche begünstigt wird.

2. Erstbenetzungshilfsmaterial zum Aufbringen auf die Verdampferfläche eines elektrisch beheizbaren keramischen Verdampferkörpers (1), welcher zum Betreiben in einer PVD-Metallisierungsanlage zum Verdampfen von Aluminium vorgesehen ist und Stickstoff, insbesondere in Form von Bornitrid, als Materialkomponente enthält, aufweisend:
ein Folienmaterial oder Blechmaterial mit Aluminium oder einer Aluminiumlegierung, das nach dem Start des Betriebs des Verdampferkörpers (1) schmilzt, so dass das Aluminium mit dem Stickstoff des Verdampferkörpers (1) unter Ausbildung einer Aluminiumnitridschicht auf der Verdampferfläche reagiert, und
ein dem Folienmaterial oder Blechmaterial zulegiertes und/oder auf das Folienmaterial oder Blechmaterial aufgebrachtes Benetzungsmittel, von dem eine gleichmäßige und großflächige Verteilung des geschmolzenen Aluminiums auf der Verdampferfläche begünstigt wird.

3. Erstbenetzungshilfsmaterial nach Anspruch 2, wobei das Benetzungsmittel pulverförmig ausgebildet ist und auf die Folie aufgebracht ist.

4. Erstbenetzungshilfsmaterial nach Anspruch 1 oder 3, wobei das Benetzungsmittel eine Korngröße von kleiner oder gleich 0,2 mm hat.

5. Erstbenetzungshilfsmaterial nach einem der vorangehenden Ansprüche, ferner aufweisend ein Klebemittel, mittels dessen das Erstbenetzungshilfsmaterial auf der Verdampferfläche klebehaftend anbringbar ist.

6. Erstbenetzungshilfsmaterial nach einem der vorangehenden Ansprüche, ferner aufweisend die Materialkomponente Zinn, wobei das Zinn in elementarer oder in gebundener Form vorliegt.

7. Erstbenetzungshilfsmaterial nach einem der vorangehenden Ansprüche, wobei die auf die Verdampferfläche des Verdampferkörpers (1) bezogene eingesetzte Masse an Benetzungsmittel 0,3 bis 400 mg/cm²_{Verdampferfläche}, vorzugsweise 1 bis 6 mg/cm²_{Verdampferfläche}, und die des Aluminiums 0,1 bis 100 mg/cm²_{Verdampferfläche}, vorzugsweise 10 bis 60 mg/cm²_{Verdampferfläche}, beträgt.

8. Erstbenetzungshilfsmaterial nach einem der vorangehenden Ansprüche, wobei das Benetzungsmittel mindestens 30 Gew.%, vorzugsweise mindestens 40 Gew.%, Zirkonium, Molybdän, Titan oder eine Kombination davon als Materialkomponente enthält, wobei die genannten Komponenten in elementarer Form oder gebunden, vorzugsweise als Borid oder Silizid, in dem Benetzungsmittel vorliegen.

9. Erstbenetzungshilfsmaterial nach einem der vorangehenden Ansprüche, wobei das Benetzungsmittel Titandiborid, Titan, Zirkoniumdiborid, Zirkonium, Titandisilizid, Zirkoniumdisilizid, Molybdändisilizid, Molybdän oder Ferrosiliziumdititanat (FeSiTi₂) ist.

10. Erstbenetzungshilfsmaterial nach Anspruch 6, wobei das Zinn in Pulverform mit einer maximalen Korngröße von 0,02 bis 0,06 mm, insbesondere 0,045 mm, bereitgestellt und dem Benetzungsmittel zugemischt ist.

11. Erstbenetzungshilfsmaterial nach Anspruch 2, wobei die Folie eine Dicke von 0,01 mm bis 4 mm, insbesondere eine Dicke von 0,01-0,1 mm oder eine Dicke von 0,2-0,3 mm, hat.

12. Erstbenetzungshilfsmaterial nach einem der Ansprüche 2-11, wobei das Benetzungsmittel auf die Folie aufgewalzt ist.

13. Erstbenetzungshilfsmaterial nach Anspruch 10, wobei das Gemisch aus Benetzungsmittel und Zinnpulver auf die Folie aufgewalzt ist.

14. Erstbenetzungshilfsmaterial nach Anspruch 2 oder 11, wobei das Benetzungsmittel dem Folienmaterial zulegiert ist, und wobei das Folienmaterial neben Aluminium und dem Benetzungsmittel als einen weiteren Legierungsbestandteil Zinn enthält.

15. Erstbenetzungshilfsmaterial nach Anspruch 10, wobei das pulverförmige Aluminium und das Gemisch aus Benetzungsmittel und Zinn zu einem Pulvergemisch gemischt sind.

16. Erstbenetzungshilfsmaterial nach Anspruch 1 oder 15, ausgebildet als eine Suspension aus flüssigem Klebemittel, insbesondere organischem Kleber oder Wachs, in welchem das Pulvergemisch dispergiert ist.

17. Erstbenetzungshilfsmaterial nach einem der Ansprüche 2-11, ausgebildet als Dualschicht (2) mit einer ersten Schicht (I) aus einem Gemisch aus organischem Acrylat-Kleber und dem Benetzungsmittel und vorzugsweise Zinnpulver und mit einer zweiten Schicht (II), die durch die Folie gebildet ist, wobei die Dicke der zweiten Schicht (II) bevorzugt größer als die Dicke der ersten Schicht (I) ist.

18. Erstbenetzungshilfsmaterial nach Anspruch 17, wobei die erste Schicht (I) 0,02-0,06 mm, bevorzugt 0,05 mm, dick ist, wobei das Benetzungsmittel Titan- und/oder Titandiboridpulver mit einer maximalen Korngröße von 0,01-0,02 mm, insbesondere 0,015 mm, ist und mit einem Gewichtsanteil von 15-40 Gew.%, insbesondere 30 Gew.%, in der ersten Schicht (I) enthalten ist, und wobei das Zinnpulver mit einem Gewichtsanteil von 5-30 Gew.%, insbesondere 30 Gew.%, in der ersten Schicht enthalten ist, und wobei die Dicke der zweiten Schicht (II) 0,045-4 mm, vorzugsweise 0,045-0,1 mm, insbesondere 0,055 mm, oder 0,2-0,3 mm, insbesondere 0,24-0,26 mm, ist.

19. Erstbenetzungshilfsmaterial nach Anspruch 2, wobei das Benetzungsmittel dem Folienmaterial zulegiert ist, wobei das Folienmaterial 90-97 Gew.% metallisches Aluminium, inklusive Verunreinigungen, und 3-10 Gew.% Titan als Benetzungsmittel aufweist.

20. Erstbenetzungshilfsmaterial nach einem der Ansprüche 2-13, ausgebildet als Dreifachschicht (2') mit einer von der Folie gebildeten ersten Schicht (I'), einer auf die erste Schicht (I') aufgebrachten zweiten Schicht (II') aus dem Benetzungsmittel und einer auf die Benetzungsmittel-Schicht aufgebrachten dritten Schicht (III) aus einem Klebemittel, insbesondere einem Acrylat-Kleber.

21. Erstbenetzungshilfsmaterial nach Anspruch 20, wobei die zweite Schicht (II') durch Aufwalzen eines Gemischs aus 0,05 g Titan und/oder Titandiborid und 0,05 g Zinn auf der Oberfläche der ersten Schicht (I') fixiert ist, wobei die Klebemittel-Schicht 0,02-0,06 mm, insbesondere 0,03 mm, dick ist, und wobei die Gesamtdicke des Erstbenetzungshilfsmaterials 0,1-4 mm, vorzugsweise 0,10-0,16 mm, insbesondere 0,13 mm, oder 0,25-0,35 mm, beträgt.

22. Erstbenetzungshilfsmaterial nach Anspruch 20 oder 21, wobei dem Benetzungsmittel und/oder dem Klebemittel Zinnpulver, vorzugsweise mit einer maximalen Korngröße von 0,02 bis 0,06 mm, insbesondere 0,045 mm, zugemischt ist.

23. Erstbenetzungshilfsmaterial nach Anspruch 5, wobei das Klebemittel eine Klebeschicht, insbesondere aus einem Acrylat-Kleber, mit einer Dicke von 0,02-0,06 mm, insbesondere 0,03 mm, ist.

24. Erstbenetzungshilfsmaterial nach Anspruch 16, wobei die Suspension Parrafin-Stearat-Wachs, Titan- und/oder Titandiborid-Pulver mit einer maximalen Korngröße von 0,015 mm und Aluminiumpulver mit einer maximalen Korngröße von 0,5 mm aufweist.

25. Erstbenetzungshilfsmaterial nach Anspruch 16, wobei die Suspension Aluminiumpulver, Titan- und/oder TitandiboridPulver, Zucker und Glykol enthält.

26. Erstbenetzungshilfsmaterial nach Anspruch 2, wobei die Folie mit einer Prägung oder einem Aufdruck versehen ist.

27. Elektrisch beheizbarer keramischer Verdampferkörper (1), der eine Verdampferfläche zum Betreiben in einer PVD-Metallisierungsanlage zum Verdampfen von Aluminium aufweist,
wobei der Verdampferkörper (1) Stickstoff, insbesondere in Form von Bornitrid, enthält und mit einem auf der Verdampferfläche aufgebrachten, insbesondere vollflächig aufgebrachten, Erstbenetzungshilfsmaterial nach einem der Ansprüche 1-26 versehen ist.

28. Verdampferkörper nach Anspruch 27, wobei der Verdampferkörper (1) eine Mischkeramik mit den Hauptkomponenten Titandiborid und Bornitrid ist, wobei ein Mischungsverhältnis von je 50 Gew.% plus/minus 10 Gew.% vorliegt.

29. Verwendung des Erstbenetzungshilfsmaterials nach einem der Ansprüche 1-26 zum Herrichten der Verdampferfläche eines Verdampferkörpers (1), welcher Stickstoff, insbesondere in Form von Bornitrid, enthält.

## Claims (Claims for the following Contracting State(s): AT,BE,BG,CH,CY,CZ,DK,EE,ES,FI,FR,GB,GR,HU,IE,IS,IT,LI,LT,LU,LV,MC,NL,PL,PT,RO,SE,SI,SK,TR)

1. Initial wetting auxiliary material for application to the vaporizer surface of an electrically heatable ceramic vaporizer body (1), which is intended for operation in a PVD metallization plant for vaporizing aluminium and contains nitrogen, in particular in the form of boron nitride, as material component, which comprises in the form of a layer material and/or a powder material in dry or suspended form:
at least two material components containing:
aluminium as first material component having such a nature that it can be melted after commencement of operation of the vaporizer body (1) on the vaporizer surface of the latter on heating the vaporizer body and is capable of reacting in the molten state with the nitrogen of the vaporizer body (1) to form an aluminium nitride layer on the vaporizer surface and
a wetting agent as second material component having such a nature that it is capable of promoting uniform and wide distribution of the molten aluminium on the vaporizer surface.

2. Initial wetting auxiliary material according to Claim 1 which further comprises an adhesive by means of which the initial wetting auxiliary material can be applied in an adhesive manner to the vaporizer surface.

3. Initial wetting auxiliary material according to Claim 1 or 2 which further comprises the material component tin, wherein the tin is present in elemental or bound form.

4. Initial wetting auxiliary material according to any of Claims 1 to 3, wherein the wetting agent contains at least 30% by weight, preferably at least 40% by weight, of zirconium, molybdenum, titanium or a combination thereof as material component, wherein the components mentioned are present in elemental form or bound, preferably as boride or silicide, in the wetting agent.

5. Initial wetting auxiliary material according to any of Claims 1 to 4, wherein the wetting agent is titanium diboride, titanium, zirconium diboride, zirconium, titanium disilicide, zirconium disilicide, molybdenum disilicide, molybdenum or ferrosilicon dititanide (FeSiTi₂).

6. Initial wetting auxiliary material according to any of Claims 1 to 5, wherein the wetting agent is pulverulent, in particular having a particle size of less than or equal to 0.2 mm.

7. Initial wetting auxiliary material according to Claims 3 and 6, wherein the tin is provided in powder form, having a maximum particle size of from 0.02 to 0.06 mm, in particular 0.045 mm, and is mixed into the wetting agent.

8. Initial wetting auxiliary material according to any of Claims 1 to 7, wherein the aluminium is pulverulent, in particular having a particle size of less than or equal to 0.5 mm.

9. Initial wetting auxiliary material according to any of Claims 1 to 7, wherein the aluminium is in the form of an aluminium foil or an aluminium sheet having a thickness of from 0.01 mm to 4 mm, in particular an aluminium foil having a thickness of 0.01-0.1 mm or an aluminium sheet having a thickness of 0.2-0.3 mm.

10. Initial wetting auxiliary material according to Claims 6 and 9, wherein the wetting agent is rolled onto the aluminium foil or the aluminium sheet.

11. Initial wetting auxiliary material according to Claims 7 and 9, wherein the mixture of wetting agent and tin powder is rolled onto the aluminium foil or the aluminium sheet.

12. Initial wetting auxiliary material according to any of Claims 1 to 5, wherein the aluminium is in the form of a foil or a sheet of an aluminium alloy which contains the aluminium together with the wetting agent as alloy constituent.

13. Initial wetting auxiliary material according to Claim 12, wherein the alloy contains aluminium and the wetting agent together with tin as further alloy constituent.

14. Initial wetting auxiliary material according to Claims 6 and 8, wherein the aluminium and the wetting agent are mixed to form a powder mixture.

15. Initial wetting auxiliary material according to Claims 7 and 8, wherein the aluminium and the mixture of wetting agent and tin are mixed to form a powder mixture.

16. Initial wetting auxiliary material according to Claim 14 or 15, in the form of a suspension of liquid adhesive, in particular an organic adhesive or wax, in which the powder mixture is dispersed.

17. Initial wetting auxiliary material according to any of Claims 1 to 7 and 9, in the form of a dual layer (2) having a first layer (I) composed of a mixture of organic acrylate adhesive and the wetting agent and preferably tin powder and a second layer (II) of aluminium or an aluminium alloy, wherein the thickness of the second layer (II) is preferably greater than the thickness of the first layer (I).

18. Initial wetting auxiliary material according to Claim 17, wherein the first layer (I) has a thickness of 0.02-0.06 mm, preferably 0.05 mm, the wetting agent is titanium powder and/or titanium diboride powder having a maximum particle size of 0.01-0.02 mm, in particular 0.015 mm, and is present in a proportion by weight of 15-40% by weight, in particular 30% by weight, in the first layer (I) and the tin powder is present in a proportion by weight of 5-30% by weight, in particular 30% by weight in the first layer and the thickness of the second layer (II) is 0.045-4 mm, preferably 0.045-0.1 mm, in particular 0.055 mm, or 0.2-0.3 mm, in particular 0.24-0.26 mm.

19. Initial wetting auxiliary material according to Claim 12, wherein the aluminium alloy comprises 90-97% by weight of metallic aluminium, including impurities, and 3-10% by weight of titanium as wetting agent.

20. Initial wetting auxiliary material according to any of Claims 1-11, in the form of a triple layer (2') having a first layer (I') formed by the aluminium foil or the aluminium sheet, a second layer (II') of the wetting agent applied to the first layer (I') and a third layer (III) of an adhesive, in particular an acrylate adhesive, applied to the wetting agent layer.

21. Initial wetting auxiliary material according to Claim 20, wherein the second layer (II') is, in particular, fixed to the surface of the first layer (I') by rolling a mixture of 0.05 g of titanium and/or titanium diboride and 0.05 g of tin onto the surface of the first layer (I'), where the adhesive layer has a thickness of 0.02-0.06 mm, in particular 0.03 mm, and the total thickness of the initial wetting auxiliary material is 0.1-4 mm, preferably 0.10-0.16 mm, in particular 0.13 mm, or 0.25-0.35 mm.

22. Initial wetting auxiliary material according to Claim 20 or 21, wherein tin powder, preferably having a maximum particle size of from 0.02 to 0.06 mm, in particular 0.045 mm, is mixed into the wetting agent and/or the adhesive.

23. Initial wetting auxiliary material according to Claim 2, wherein the adhesive is an adhesive layer, in particular of an acrylate adhesive, having a thickness of 0.02-0.06 mm, in particular 0.03 mm, and the total thickness of the initial wetting auxiliary material is 0.07-4 mm, preferably 0.07-0.16 mm, in particular 0.10-0.13 mm, or 0.02-0.035 mm.

24. Initial wetting auxiliary material according to Claim 16, wherein the suspension comprises paraffin stearate wax, titanium powder and/or titanium diboride powder having a maximum particle size of 0.015 mm, and aluminium powder having a maximum particle size of 0.5 mm.

25. Initial wetting auxiliary material according to Claim 16, wherein the suspension contains aluminium powder, titanium powder and/or titanium diboride powder, sugar and glycol.

26. Initial wetting auxiliary material according to Claim 9 or 12, wherein the foil or the sheet is provided with embossing or printing.

27. Electrically heatable vaporizer body (1), in particular a ceramic vaporizer body, which has a vaporizer surface for operation in a PVD metallization plant for vaporizing aluminium, wherein the vaporizer body (1) contains nitrogen, in particular in the form of boron nitride, and is provided with an initial wetting auxiliary material according to any of Claims 1-26 applied to the vaporizer surface, in particular applied over the full area thereof.

28. Vaporizer body according to Claim 27, wherein the vaporizer body (1) is a mixed ceramic having the main components titanium diboride and boron nitride, where the mixing ratio of each is 50% by weight plus/minus 10% by weight.

29. Vaporizer body according to Claim 27 or 28, wherein the mass of wetting agent used, based on the vaporizer surface of the vaporizer body (1), is from 0.3 to 400 mg/cm²_{vaporizer} surface, preferably from 1 to 6 mg/cm²_{vaporizer} surface, and that of aluminium is from 0.1 to 100 mg/cm²_{vaporizer} surface, preferably from 10 to 60 mg/cm²_{vaporizer} surface.

30. Process for making an electrically heatable vaporizer body (1), in particular a ceramic vaporizer body (1), which is intended for operation in a PVD metallization plant for vaporizing aluminium and contains nitrogen, in particular in the form of boron nitride, as material component, wherein an initial wetting auxiliary material according to any of Claims 1-26, is applied to the vaporizer surface of the vaporizer body (1) over at least part of the area thereof, in particular essentially the entire area thereof, before the vaporizer body (1) is heated.

31. Process according to Claim 30 in which the initial wetting auxiliary material is introduced in the form of a suspension according to Claim 24 or 25 into a cavity (3) of the vaporizer body (I').

32. Process according to Claim 30, wherein the suspension according to Claim 25 is applied in a layer thickness of 0.05-2.0 mm, in particular 0.10-0.20 mm, to the vaporizer surface of the vaporizer body.

33. Process according to Claim 31 or 32, wherein a suspension having a melting point above a temperature of 70°C is used and the suspension is solidified by cooling and provided with embossing after application to the vaporizer surface of the vaporizer body (1).

## Claims (Claims for the following Contracting State(s): DE)

1. Initial wetting auxiliary material for application to the vaporizer surface of an electrically heatable ceramic vaporizer body (1), which is intended for operation in a PVD metallization plant for vaporizing aluminium and contains nitrogen, in particular in the form of boron nitride, as material component, which comprises a powder mixture comprising:
pulverulent aluminium which has a particle size of less than or equal to 0.6 mm and melts after the commencement of operation of the vaporizer body (1) to form an aluminium nitride layer on the vaporizer surface and
pulverulent wetting agent by means of which a uniform and wide distribution of the molten aluminium on the vaporizer surface is promoted.

2. Initial wetting auxiliary material for application to the vaporizer surface of an electrically heatable ceramic vaporizer body (1), which is intended for operation in a PVD metallization plant for vaporizing aluminium and contains nitrogen, in particular in the form of boron nitride, as material component, which comprises :
a foil material or sheet material which comprises aluminium or an aluminium alloy and melts afterthe commencement of operation of the vaporizer body (1), so that the aluminium reacts with the nitrogen of the vaporizer body (1) to form an aluminium nitride layer on the vaporizer surface and
a wetting agent which is alloyed into the foil material or sheet material and/or appiled to the foil material or sheet material and which promotes uniform and wide distribution of the molten aluminium on the vaporizer surface.

3. Initial wetting auxiliary material according to Claim 2, wherein the wetting agent is pulverulent and is applied to the foil.

4. Initial wetting auxiliary material according to Claim 1 or3, wherein the wetting agent has a particle size of less than or equal to 0.2 mm.

5. Initial wetting auxiliary material according to any of the preceding claims, which further comprises an adhesive by means of which the initial wetting auxiliary material can be applied in an adhesive manner to the vaporizer surface.

6. Initial wetting auxiliary material according to any of the preceding claims, which further comprises the material component tin, wherein the tin is present in elemental or bound form.

7. Initial wetting auxiliary material according to any of the preceding claims, wherein the mass of wetting agent, based on the vaporizer surface of the vaporizer body (1), is from 0.3 to 400 mg/cm²_{vaporizer surface}, preferably from 10 to 60 mg/cm²_{vaporizer surface}.

8. Initial wetting auxiliary material according to any of the preceding claims, wherein the wetting agent contains at least 30% by weight, preferably at least 40% by weight, or zirconium, molybdenum, titanium or a combination thereof as material component, wherein the components mentioned are present in elemental form of bound, preferably as boride or silicide, in the wetting agent.

9. Initial wetting auxiliary material according to any of the preceding claims, wherein the wetting agent is titanium diboride, titanium, zirconium diboride, zirconium, titanium disilicide, zirconium disilicide, molybdenum disilicide, molybdenum or ferrosilicon dititanide (FeSiTi₂).

10. Initial wetting auxiliary material according to Claim 6, wherein the tin is provided in powder form having a maximum particle size of from 0.02 to 0.06 mm, in particluar 0.045 mm, and is mixed into the wetting agent.

11. Initial wetting auxiliary material according to Claim 2, wherein the foil has a thickness of from 0.01 mm to 4 mm, in particular a thickness of 0.01-0.1 mm or a thickness of 0.2-0.3 mm.

12. Initial wetting auxiliary material according to Claims 2-11, wherein the wetting agent is rolled onto the foil.

13. Initial wetting auxiliary material according to Claim 10, wherein the mixture of wetting agent and tin powder is rolled onto the foil.

14. Initial wetting auxiliary material according to Claim 2 or 11, wherein the wetting agent is alloyed into the foil material and the foilmaterial contains aluminium and the wetting agent together with tin as a further alloy constituent.

15. Initial wetting auxiliary material according to Claim 10, wherein the pulverulent aluminium and the mixture of wetting agent and tin are mixed to form a powder mixture.

16. Initial wetting auxiliary material according to Claim 1 or 15, in the form of a suspension of liquid adhesive, in particular an organic adhesive or wax, in which the powder mixture is dispersed.

17. Initial wetting auxiliary material according to Claims 2-11, in the form of a dual layer (2) having a first layer (I) composed of a mixture of organic acrylate adhesive and the wetting agent and preferably tin powder and a second layer (II) formed by the foil, wherein the thickness of the seconf layer (II) is preferably greater than the thickness of the first layer (I).

18. Initial wetting auxiliary material according to Claim 17, wherein the first layer (I) has a thickness of 0.02-0.06 mm, preferably 0.05 mm, the wetting agent is titanium powder and/or titanium diboride powder having a maximum particle size of 0.01-0.02 mm, in particular 0.015 mm, and is present in a proportion by weight of 15-40% by weight, in particular 30% by weight, in the first layer (I) and the tin powder is present in a proportion by weight of 5-30% by weight, in particular 30% by weight in the first layer and the thickness of the second layer (II) is 0.045-4 mm, preferably 0.045-0.1 mm, in particular 0.055 mm, or 0.2-0.3 mm, in particular 0.24-0.26 mm.

19. Initial wetting auxiliary material according to Claim 2, wherein the wetting agent is alloyed into the foil material and the foil material comprises 90-97% by weight of metallic aluminium, including impurities, and 3-10% by weight of titanium as wetting agent.

20. Initial wetting auxiliary material according to Claims 2-13, in the form of a triple layer (2') having a first layer (I') formed by the foil, a second layer (II') of the wetting agent applied to the first layer (I') and a third layer (III) of an adhesive, in particular an acrylate adhesive, applied to the wetting agent layer.

21. Initial wetting auxiliary material according to Claim 20, wherein the second layer (II') is fixed to the surface of the first layer (I') by rolling a mixture of 0.05 g of titanium and/or titanium diboride and 0.05 g of tin into the surface of the first layer (I'), where the adhesive layer has a thickness of 0.02-0.06 mm, in particular 0.03 mm, and the total thickness of the initial wetting auxiliary material is 0.1-4 mm, preferably 0.10-0.16 mm, in particular 0.13 mm, or 0.25-0.35 mm.

22. Initial wetting auxiliary material according to Claim 20 or 21, wherein tin powder, preferably having a maximum particle size of from 0.02 to 0.06 mm, in particular 0.045 mm, is mixed into the wetting agent and/or the adhesive.

23. Initial wetting auxiliary material according to Claim 5, wherein the adhesive is an adhesive layer, in particular of an acrylate adhesive, having a thickness of 0.02-0.06 mm, in particular 0.03 mm.

24. Initial wetting auxiliary material according to Claim 16, wherein the suspension comprises paraffin stearate wax, titanium powder and/or titanium diboride powder having a maximum particle size of 0.015 mm, and aluminium powder having a maximum particle size of 0.5 mm.

25. Initial wetting auxiliary material according to Claim 16, wherein the suspension contains aluminium powder, titanium powder and/or titanium diboride powder, sugar and glycol.

26. Initial wetting auxiliary material according to Claim 2, wherein the foil is provided with embossing or printing.

27. Electrically heatable vaporizer body (1), which has a vaporizer surface for operation in a PVD metallization plant for vaporizing aluminium,
wherein the vaporizer body (1) contains nitrogen, in particular in the form of boron nitride, and is provided with an initial wetting auxiliary material according to any of Claims 1-26 applied to the vaporizer surface, in particular applied over the full area thereof.

28. Vaporizer body according to Claim 27, wherein the vaporizer body (1) is a mixed ceramic having the main components titanium diboride and boron nitride, where the mixing ratio of each is 50% by weight plus/minus 10% by weight.

29. Use of the initial wetting auxiliary material according to any of Claims 1-26 for making the vaporizer surface of a vaporizer body (1) which contains nitrogen, in particular in the form of boron nitride.

## Revendications (Revendications pour l'(les) Etat(s) contractant(s) suivant(s): AT,BE,BG,CH,CY,CZ,DK,EE,ES,FI,FR,GB,GR,HU,IE,IS,IT,LI,LT,LU,LV,MC,NL,PL,PT,RO,SE,SI,SK,TR)

1. Matériau auxiliaire de mouillage initial destiné à être appliqué sur la surface d'évaporation d'un corps céramique d'évaporateur (1) chauffé électriquement et destiné à être utilisé pour vaporiser de l'aluminium dans une installation de métallisation par PVD,
le matériau contenant comme composant de l'azote, en particulier sous la forme de nitrure de bore, et présentant sous la forme d'un matériau stratifié et/ou d'un matériau poudreux sous forme sèche ou en suspension au moins deux composants, à savoir :
comme premier composant du matériau, de l'aluminium sous une forme telle qu'après le début de la mise en service du corps d'évaporateur (1), il peut fondre sur sa surface d'évaporation lors de l'échauffement du corps d'évaporateur et est en mesure de réagir à l'état fondu avec l'azote du corps d'évaporateur (1) pour former une couche de nitrure d'aluminium sur la surface d'évaporation et
comme deuxième composant du matériau, un agent de mouillage sous une forme telle qu'il est en mesure de favoriser une répartition uniforme et sur une grande surface de l'aluminium fondu sur la surface d'évaporation.

2. Matériau auxiliaire de mouillage initial selon la revendication 1, présentant en outre un agent adhésif au moyen duquel le matériau auxiliaire de mouillage initial peut être appliqué de manière adhérente sur la surface d'évaporation.

3. Matériau auxiliaire de mouillage initial selon les revendications 1 ou 2, présentant en outre comme composant du matériau de l'étain, l'étain se présentant sous forme élémentaire ou sous forme liée.

4. Matériau auxiliaire de mouillage initial selon l'une des revendications 1 à 3, dans lequel l'agent de mouillage contient comme composant du matériau au moins 30 % en poids et de préférence au moins 40 % en poids de zirconium, de molybdène, de titane ou d'une de leurs combinaisons, lesdits matériaux se présentant dans l'agent de mouillage sous forme élémentaire ou sous forme liée, de préférence comme borure ou siliciure.

5. Matériau auxiliaire de mouillage initial selon l'une des revendications 1 à 4, dans lequel l'agent de mouillage est le diborure de titane, le titane, le diborure de zirconium, le zirconium, le disilisure de titane, le disilisure de zirconium, le disilisure de molybdène, le molybdène ou le dititanure de ferrosilicium (FeSiTi₂).

6. Matériau auxiliaire de mouillage initial selon l'une des revendications 1 à 5, dans lequel l'agent de mouillage présente la forme d'une poudre et en particulier d'une poudre dont les grains ont une taille inférieure ou égale à 0,2 mm.

7. Matériau auxiliaire de mouillage initial selon les revendications 3 et 6, dans lequel l'étain est préparé sous forme poudreuse en grains d'une taille maximale de 0,02 à 0,06 mm et en particulier de 0,045 mm et est mélangé à l'agent de mouillage.

8. Matériau auxiliaire de mouillage initial selon l'une des revendications 1 à 7, dans lequel l'aluminium présente la forme d'une poudre de grains dont la taille est en particulier inférieure ou égale à 0,5 mm.

9. Matériau auxiliaire de mouillage initial selon l'une des revendications 1 à 7, dans lequel l'aluminium présente la forme d'une feuille d'aluminium ou d'une plaque d'aluminium dont l'épaisseur est comprise entre 0,01 mm et 4 mm, et en particulier sous la forme d'une feuille d'aluminium d'une épaisseur de 0,01 à 0,1 mm ou d'une plaque d'aluminium d'une épaisseur de 0,2 à 0,3 mm.

10. Matériau auxiliaire de mouillage initial selon les revendications 6 et 9, dans lequel l'agent de mouillage est laminé sur la feuille d'aluminium ou sur la plaque d'aluminium.

11. Matériau auxiliaire de mouillage initial selon les revendications 7 et 9, dans lequel le mélange constitué de l'agent de mouillage et de la poudre d'étain est laminé sur la feuille d'aluminium ou sur la plaque d'aluminium.

12. Matériau auxiliaire de mouillage initial selon l'une des revendications 1 à 5, dans lequel l'aluminium présente la forme d'une feuille ou d'une plaque d'alliage d'aluminium qui, en plus d'aluminium, contient l'agent de mouillage comme composant d'alliage.

13. Matériau auxiliaire de mouillage initial selon la revendication 12, dans lequel l'alliage contient en plus de l'aluminium et de l'agent de mouillage de l'étain comme autre composant d'alliage.

14. Matériau auxiliaire de mouillage initial selon les revendications 6 et 8, dans lequel l'aluminium et l'agent de mouillage sont mélangés pour former un mélange de poudre.

15. Matériau auxiliaire de mouillage initial selon les revendications 7 et 8, dans lequel l'aluminium et le mélange constitué de l'agent de mouillage et de l'étain sont mélangés en un mélange de poudre.

16. Matériau auxiliaire de mouillage initial selon les revendications 14 ou 15, configuré comme suspension constituée d'un agent adhésif liquide, en particulier d'un agent ou d'une cire organiques, dans lesquels le mélange de poudre est dispersé.

17. Matériau auxiliaire de mouillage initial selon l'une des revendications 1 à 7 et 9, configuré comme couche double (2) constituée d'une première couche (I) en un mélange d'adhésif organique à l'acrylate, de l'agent de mouillage et de préférence de la poudre de zinc, et d'une deuxième couche (II) d'aluminium ou d'alliage d'aluminium, l'épaisseur de la deuxième couche (II) étant de préférence supérieure à l'épaisseur de la première couche (I).

18. Matériau auxiliaire de mouillage initial selon la revendication 17, dans lequel la première couche (I) a une épaisseur de 0,02 à 0,06 mm et de préférence de 0,05 mm, l'agent de mouillage étant une poudre de titane et/ou de borure de titane dont les grains ont une taille maximale de 0,01 à 0,02 mm et en particulier de 0,015 mm à une proportion pondérale de 15 à 40 % en poids et en particulier de 30 % en poids dans la première couche (I), la première couche contenant la poudre de zinc en une proportion pondérale de 5 à 30 % en poids et en particulier de 30 % en poids et l'épaisseur de la deuxième couche (II) étant de 0,045 à 4 mm, de préférence de 0,045 à 0,1 mm et en particulier de 0,055 mm ou de 0,2 à 0,3 mm et en particulier de 0,24 à 0,26 mm.

19. Matériau auxiliaire de mouillage initial selon la revendication 12, dans lequel l'alliage d'aluminium présente de 90 à 97 % en poids d'aluminium métallique, y compris les impuretés, et de 3 à 10 % en poids de titane comme agent de mouillage.

20. Matériau auxiliaire de mouillage initial selon l'une des revendications 1 à 11, configuré comme couche triple (2') présentant une première couche (I') formée de la feuille d'aluminium ou de la plaque d'aluminium, une deuxième couche (II') appliquée sur la première couche (I') et constituée de l'agent de mouillage et d'une troisième couche (III), en un agent adhésif et en particulier en un adhésif à l'acrylate, appliqué sur la couche d'agent de mouillage.

21. Matériau auxiliaire de mouillage initial selon la revendication 20, dans lequel la deuxième couche (II') est fixée en particulier par laminage d'un mélange constitué de 0,05 g de titane et/ou de borure de titane et de 0,05 g d'étain sur la surface de la première couche (I'), la couche d'agent adhésif ayant une épaisseur de 0,02 à 0,06 mm et en particulier de 0,03 mm et l'épaisseur totale du matériau auxiliaire de mouillage initial étant de 0,1 à 4 mm, de préférence de 0,10 à 0,16 mm et en particulier de 0,13 mm ou de 0,25 à 0,35 mm.

22. Matériau auxiliaire de mouillage initial selon les revendications 20 ou 21, dans lequel de la poudre d'étain, de préférence en grains d'une taille maximale de 0,02 à 0,06 mm et en particulier de 0,045 mm est ajoutée à l'agent de mouillage et/ou à l'agent adhésif.

23. Matériau auxiliaire de mouillage initial selon la revendication 2, dans lequel l'agent adhésif est une couche d'adhésif, constituée en particulier d'un adhésif à l'acrylate, d'une épaisseur de 0,02 à 0,06 mm et en particulier de 0,03 mm, l'épaisseur totale du matériau auxiliaire de mouillage initial étant de 0,07 à 4 mm, de préférence de 0,07 à 0,16 mm et en particulier de 0,10 à 0,13 mm ou de 0,02 à 0,035 mm.

24. Matériau auxiliaire de mouillage initial selon la revendication 16, dans lequel la suspension présente de la cire de paraffine et de stéarate, de la poudre de titane et/ou de diborure de titane en grains d'une taille maximale de 0,015 mm et de la poudre d'aluminium en grains d'une taille maximale de 0,5 mm.

25. Matériau auxiliaire de mouillage initial selon la revendication 16, dans lequel la suspension contient une poudre d'aluminium, une poudre de titane et/ou de diborure de titane, du sucre et du glycol.

26. Matériau auxiliaire de mouillage initial selon les revendications 9 ou 12, dans lequel la feuille ou la plaque sont dotées d'une empreinte ou d'une impression.

27. Corps d'évaporateur (1) chauffé électriquement, en particulier corps céramique d'évaporateur, qui présente une surface d'évaporation et destiné à être utilisé pour évaporer de l'aluminium dans une installation de métallisation par PVD,
le corps d'évaporateur (1) contenant de l'azote, en particulier sous la forme de nitrure de bore, et doté d'un matériau auxiliaire de mouillage initial selon l'une des revendications 1 à 26 appliqué sur la surface d'évaporation et en particulier appliqué sur la totalité de cette surface.

28. Corps d'évaporateur selon la revendication 27, dans lequel le corps d'évaporateur (1) est une céramique mixte qui présente comme composants principaux le diborure de titane et le nitrure de bore, dans un rapport de mélange de 50 % en poids plus ou moins 10 % en poids.

29. Corps d'évaporateur selon les revendications 27 ou 28, dans lequel la masse d'agent de mouillage utilisé sur la surface d'évaporation du corps d'évaporateur (1) représente de 0,3 à 400 mg/cm² surface d'évaporateur, de préférence de 1 à 6 mg/cm² surface d'évaporateur, et celle de l'aluminium de 0,1 à 100 mg/cm² surface d'évaporation et de préférence de 10 à 60 mg/cm² surface d'évaporation.

30. Procédé de formation d'un corps d'évaporateur (1) chauffé électriquement, en particulier d'un corps céramique d'évaporateur (1), destiné à être utilisé pour évaporer de l'aluminium dans une installation de métallisation par PVD et contenant de l'azote, en particulier sous la forme de nitrure de bore, comme composant du matériau, un matériau auxiliaire de mouillage initial selon l'une des revendications 1 à 26 étant appliqué au moins sur des parties de la surface et en particulier essentiellement sur toute la surface d'évaporation du corps d'évaporateur (1) avant son chauffage.

31. Procédé selon la revendication 30, dans lequel le matériau auxiliaire de mouillage initial est appliqué sous la forme d'une suspension selon les revendications 24 ou 25, dans une cavité (3) du corps d'évaporateur (I').

32. Procédé selon la revendication 30, dans lequel la suspension selon la revendication 25 est appliquée sur la surface d'évaporation du corps d'évaporateur (1) en une couche d'une épaisseur de 0,05 à 2,0 mm et en particulier de 0,10 à 0,20 mm.

33. Procédé selon les revendications 31 ou 32, qui utilise une suspension dont la point de fusion est situé au-dessus d'une température de 70°C, la suspension étant solidifiée par refroidissement après avoir été appliquée sur la surface d'évaporation du corps d'évaporateur (1) et étant dotée d'une empreinte.

## Revendications (Revendications pour l'(les) Etat(s) contractant(s) suivant(s): DE)

1. Matériau auxiliaire de mouillage initial destiné à être appliqué sur la surface d'évaporation d'un corps céramique d'évaporateur (1) chauffé électriquement et destiné à être utilisé pour vaporiser de l'aluminium dans une installation de métallisation par PVD,
le matériau contenant comme composant de l'azote, en particulier sous la forme de nitrure de bore, et présentant un mélange de poudre qui contient :
de l'aluminium pulvérulent en grains d'une taille inférieure ou égale à 0,6 mm, qui fond sur la surface d'évaporation du corps d'évaporateur (1) après le début du fonctionnement et qui réagit avec l'azote du corps d'évaporateur (1) pour former une couche de nitrure d'aluminium sur la surface d'évaporation et
un moyen pulvérulent de mouillage au moyen duquel une répartition uniforme et de grande surface de l'aluminium est favorisée sur la surface d'évaporation.

2. Matériau auxiliaire de mouillage initial destiné à être appliqué sur la surface d'évaporation d'un corps céramique d'évaporateur (1) chauffé électriquement et destiné à être utilisé pour vaporiser de l'aluminium dans une installation de métallisation par PVD,
le matériau contenant comme composant de l'azote, en particulier sous la forme de nitrure de bore et présentant :
un matériau en feuille ou un matériau en plaquecontenant de l'aluminium ou un alliage d'aluminium qui fondent après le lancement du fonctionnement du corps d'évaporateur (1) de telle sorte que l'aluminium réagit avec l'azote du corps d'évaporateur (1) pour former une couche de nitrure d'aluminium sur la surface d'évaporation et
un agent de mouillage allié au matériau en feuille ou au matériau en plaque et/ou appliqué sur le matériau en feuille ou le matériau en plaque, et qui favorise une répartition uniforme et sur une grande surface de l'aluminium fondu sur la surface d'évaporation.

3. Matériau auxiliaire de mouillage initial selon la revendication 2, dans lequel l'agent de mouillage est en forme de poudre et est appliqué sur la feuille.

4. Matériau auxiliaire de mouillage initial selon les revendications 1 ou 3, dans lequel l'agent de mouillage présente des grains d'une taille inférieure ou égale à 0,2 mm.

5. Matériau auxiliaire de mouillage initial selon l'une des revendications précédentes, présentant en outre un adhésif au moyen duquel le matériau auxiliaire de mouillage initial peut être appliqué sur la surface d'évaporation de manière à y adhérer.

6. Matériau auxiliaire de mouillage initial selon l'une des revendications précédentes, présentant en outre comme composant du matériau de l'étain, l'étain se présentant sous forme élémentaire ou sous forme liée.

7. Matériau auxiliaire de mouillage initial selon l'une des revendications précédentes, dans lequel la masse d'agent de mouillage utilisé sur la surface d'évaporation du corps d'évaporateur (1) représente de 0,3 à 400 mg/cm²_{surface d'évaporateur}, de préférence de 1 à 6 mg/cm²_{surface d'évaporateur}, et celle de l'aluminium de 0,1à 100 mg/cm²_{surface d'évaporation} et de préférence de 10 à 60 mg/cm²_{surface d'évaporation}

8. Matériau auxiliaire de mouillage initial selon l'une des revendications précédentes, dans lequel l'agent de mouillage contient comme composant du matériau au moins 30% en poids et de préférence au moins 40% en poids de zirconium, de molybdène, de titane ou d'une de leurs combinaisons, lesdits matériaux se présentant dans l'agent de mouillage sous forme élémentaire ou sous forme liée, de préférence comme borure ou siliciure.

9. Matériau auxiliaire de mouillage initial selon l'une des revendications précédentes, dans lequel l'agent de mouillage est le biborure de titane, le titane, le tiborure de zirconium, le zirconium, le disiliciure de titane, le disiliciure de zirconium, le dilisiciure de molybdène, le molybdène ou le dititanure de ferrosilicium (FeSiTi₂).

10. Matériau auxiliaire de mouillage initial selon l'une des revendications précédentes, dans lequel l'étain est préparé sous forme poudreuse en grains d'une taille maximale de 0,02 à 0,06 mm et en particulier de 0,045 mm et est mélangé à l'agent de mouillage.

11. Matériau auxiliaire de mouillage initial selon la revendication 2, dans lequel la feuille a une épaisseur de 0,01 à 4 mm et en particulier une épaisseur de 0,01 à 0,1 mm ou une épaisseur de 0,2 à 0,3 mm.

12. Matériau auxiliaire de mouillage initial selon l'une des revendications 2 à 11, dans lequel l'agent de mouillage est laminé sur la feuille.

13. Matériau auxiliaire de mouillage initial selon la revendication 10, dans lequel le mélange constitué de l'agent de mouillage et de poudre d'étain est laminésur la feuille

14. Matériau auxiliaire de mouillage initial selon les revendications 2 ou 11, dans lequel l'agent de mouillage est allié au matériau de la feuille, le matériau de la feuille contenant en plus de l'aluminium et de l'agent de mouillage de l'étain comme autre composant d'alliage.

15. Matériau auxiliaire de mouillage initial selon la revendication 10, dans lequel l'aluminium en forme de poudre et le mélange constitué de l'agent de mouillage et de l'étain sont mélangés pour former un mélange de poudre.

16. Matériau auxiliaire de mouillage initial selon les revendications 1 ou 15, configuré sous la forme d'une suspension de l'adhésif liquide, en particulier d'un adhésif organique ou de cire, dans lequel le mélange de poudre est dispersé.

17. Matériau auxiliaire de mouillage initial selon l'une des revendications 2 à 11, configuré comme couche double (2) constituée d'une première couche (I) en un mélange d'adhésif organique à l'acrylate, de l'agent de mouillage et de préférence de la poudre de zinc, et d'une deuxième couche (II) formée par la feuille, l'épaisseur de la deuxième couche (II) étant de préférence supérieure à l'épaisseur de la première couche (I).

18. Matériau auxiliaire de mouillage initial selon la revendication 17, dans lequel la première couche (I) a une épaisseur de 0,02 à 0,06 mm et de préference de 0,05 mm, l'agent de mouillage étant une poudre de titane et/ou de borure de titane dont les grains ont une taille maximale de 0,01 à 0,02 mm et en particulier de 0,015 mm à une proportion pondérale de 15 à 40% en poids et en particulier de 30% en poids dans lapremière couche (I), la première couche contenant de la poudre de zinc en une proportion pondérale de 5 à 30% en poids et en particulier de 30% en poids et l'épaisseur de la deuxième couche (II) étant de 0,045 à 4 mm, de préférence 0,045 à 0,1 mm et en particulier de 0,24 à 0,26 mm.

19. Matériau auxiliaire de mouillage initial selon la revendication 2 , dans lequel l'agent de mouillage est allié au matériau de la feuille, le matériau de la feuille présentant de 90 à 97% en poids d'aluminium métallique, y compris les impuretés, et de 3 à 10% en poids de titane servant d'agent de mouillage.

20. Matériau auxiliaire de mouillage initial selon l'une des revendications 2 à 13, configuré comme couche triple (2') présentant une première couche (I') formée de la feuille d'aluminium ou de la plaque d'aluminium, une deuxième couche (II') et constituée de l'agent de mouillage et d'une troisème couche (III), en un agent adhésif et en particulier en un adhésif à l'acrylate, appliqué sur la couche d'agent de mouillage.

21. Matériau auxiliaire de mouillage initial selon la revendication 20, dans lequel la deuxième couche (II') est fixée en particulier par laminage d'un mélange constitué de 0,05 g de titane et/ou de borure de titane et de 0,05 g d'étain sur la surface de la première couche (I'), la couche d'agent adhésif ayant une épaisseur de 0,02 à 0,06 mm et en particulier de 0,03 mm et l'épaisseur totale du matériau auxiliaire de mouillage initial étant de 0,1 à 4 mm, de préférence de 0,10 à 0,16 mm et en particulier de 0,13 ou de 0,25 à 0,35 mm.

22. Matériau auxiliaire de mouillage initial selon l'une des revendications 20 ou 21 dans lequel de la poudred'étain, de préférence en grains d'une taille maximale de 0,02 à 0,06 mm et en particulier de 0,045 mm est ajoutée à l'agent de mouillage et/ou à l'agent adhésif.

23. Matériau auxiliaire de mouillage initial selon la revendication 5, dans lequel l'adhésif est une couche d'adhésif, en particulier d'adhésif à l'acrylate, d'une épaisseur de 0,02 à 0,06 mm et en particulier de 0,03 mm.

24. Matériau auxiliaire de mouillage initial selon la revendication 16, dans lequel la suspension présente de la cire de paraffine et de stéarate, de la poudre de titane et/ou de diborure de titane en grains d'une taille maximale de 0,015 mm et de la poudre d'aluminium en grains d'une taille maximale de 0,5 mm.

25. Matériau auxiliaire de mouillage initial selon la revendication 16, dans lequel la suspension une poudre d'aluminium, une poudre de titane et/ou de diborure de titane, de sucre et du glycol.

26. Matériau auxiliaire de mouillage initial selon la revendication 2, dans lequel la feuille est dotée d'une empreinte ou d'une impression.

27. Corps d'évaporateur (1) chauffé électriquement, en particulier corps céramique d'évaporateur, qui présente une surface d'évaporation et destiné à être utilisé pour évaporer de l'aluminium dans une installation de métallisation par PVD,
le corps d'évaporateur (1) contenant de l'azote, en particulier sous la forme de nitrure de bore, et doté d'un matériau auxiliaire de mouillage initial selon l'une des revendications 1 à 26 appliqué sur la surface d'évaporation et en particulier appliqué sur la totalité de cette surface.

28. Corps d'évaporateur selon la revendication 27,dans le quel le corps d'évaporateur (1) est une céramique mixte qui présente comme composants principaux le diborure de titane et le nitrure de bore, dans un rapport de mélange de 50% en poids plus ou moins 10% en poids

29. Utilisation du matériau auxiliaire de mouillage initial selon l'une des revendications 1 à 26, en vue de former la surface d'évaporation d'un corps d'évaporateur (1) qui contient de l'azote en particulier sous la forme de nitrure de bore.
